# EUROPEAN PATENT APPLICATION

(11) **EP 4 354 483 A1**
(43) Date of publication of application: **17.04.2024**
(21) Application number: 22200582.9
(22) Date of filing: 10.10.2022
(51) Int. Cl.: H01J 37/04, H01J 37/09

(54) **ALIGNMENT OF ELECTRON-OPTICAL ELEMENTS**

(71) Applicant: ASML Netherlands B.V., 5500 AH Veldhoven (NL)
(72) Inventor: DE LANGEN, Johannes, Cornelis, Jacobus, 5500 AH Veldhoven (NL); KONING, Johan, Joost, 5500 AH Veldhoven (NL); SCHEFFERS, Paul, IJmert, 5500 AH Veldhoven (NL); DEL TIN, Laura, 5500 AH Veldhoven (NL); STEUNEBRINK, Martin, 5500 AH Veldhoven (NL)
(74) Representative: ASML Netherlands B.V.

(57) **Abstract**

A stack of planar elements for a charged particle-optical module configured to project charged particles along a beam path, the stack comprising: a pair of adjoining planar elements arranged across the beam path, wherein one of the planar elements comprises an alignment fiducial and the other of the planar elements comprises a monitoring aperture; wherein the pair of planar elements are positioned relative to each other such that the alignment fiducial and the monitoring aperture are aligned with each other in a direction substantially perpendicular to a plane of the planar elements.

## Description

### FIELD

The embodiments provided herein generally relate to a method for aligning charged particle-optical elements, a method of making a charged particle-optical module, a stack of charged particle-optical elements, a charged particle-optical module, a charged particle-optical device, a charged particle-optical apparatus and an alignment apparatus.

### BACKGROUND

When manufacturing semiconductor integrated circuit (IC) chips, undesired pattern defects may occur on a substrate (e.g. wafer) or a mask during the fabrication processes, thereby reducing the yield. Defects may occur as a consequence of, for example, optical effects and incidental particles or other processing step such as etching, deposition of chemical mechanical polishing. Monitoring the extent of the undesired pattern defects is therefore an important process in the manufacture of IC chips. More generally, the assessment (such as inspection and/or measurement) of a surface of a substrate, or other object/material, is an important process during and/or after its manufacture.

Pattern assessment tools with a charged particle beam have been used to assess objects, for example to detect pattern defects. These tools typically use electron microscopy techniques, such as a scanning electron microscope (SEM). In a SEM, a primary electron beam of electrons at a relatively high energy is targeted with a final deceleration step in order to land on a target at a relatively low landing energy. The beam of electrons is focused as a probing spot on the target. The interactions between the material structure at the probing spot and the landing electrons from the beam of electrons cause electrons to be emitted from the surface, such as secondary electrons, backscattered electrons or Auger electrons, which together may be referred as signal electrons or more generally signal particles. The generated secondary electrons may be emitted from the material structure of the target.

By scanning the primary electron beam as the probing spot over the target surface, secondary electrons can be emitted across the surface of the target. By collecting these emitted secondary electrons from the target surface, an assessment tool (or apparatus) may obtain an image-like signal representing characteristics of the material structure of the surface of the target. In such assessment the collected secondary electrons are detected by a detector within the apparatus. The detector generates a signal in response to the incidental particle. As an area of the sample is assessed, the signals comprise data which is processed to generate the assessment image corresponding to the assessed area of the sample. The image may comprise pixels. Each pixel may correspond to a portion of the assessed area. Typically an electron beam assessment apparatus has a single beam and may be referred to as a Single Beam SEM. There have been attempts to introduce a multi-electron beam assessment in an apparatus (or a 'multi-beam tool') which may be referred to as Multi Beam SEM (MBSEM).

Another application for an electron-optical device (or device or column) is lithography. The charged particle beam reacts with a resist layer on the surface of a substrate. A desired pattern in the resist can be created by controlling the locations on the resist layer that the charged particle beam is directed towards.

An electron-optical device may be an apparatus for generating, illuminating, projecting and/or detecting one or more beams of charged particles. The path of the beam of charged particles is controlled by electromagnetic fields (i.e. electrostatic fields and magnetic fields). Stray electromagnetic fields can undesirably divert the beam.

In some electron-optical devices there may be a plurality of electron-optical elements stacked relative to each other. For example, in some electron-optical device an electrostatic field is typically generated between two electrodes corresponding to two electron-optical elements. There exists a need for accurate alignment between electron-optical elements within the stack.

### SUMMARY

The present invention provides a suitable architecture to enable alignment of charged particle-optical elements to be verified. According to a first aspect of the invention, there is provided a stack of planar elements for a charged particle-optical module configured to project charged particles along a beam path, the stack comprising: a pair of adjoining planar elements arranged across the beam path, wherein one of the planar elements comprises an alignment fiducial and the other of the planar elements comprises a monitoring aperture; wherein the pair of planar elements are positioned relative to each other such that the alignment fiducial and the monitoring aperture are aligned with each other in a direction substantially perpendicular to a plane of the planar elements.

According to a second aspect of the invention, there is provided a method for aligning planar elements for a charged particle-optical module configured to project charged particles along a beam path, the method comprising: providing a first planar element comprising a first alignment fiducial; providing a second planar element comprising a first monitoring aperture stacked relative to the first planar element; interrogating the first alignment fiducial with interrogation light through the first monitoring aperture; detecting interrogation light reflected from the first planar element; and aligning the second planar element relative to the first planar element based on the detected interrogation light.

Advantages of the present invention will become apparent from the following description taken in conjunction with the accompanying drawings wherein are set forth, by way of illustration and example, certain embodiments of the present invention.

### BRIEF DESCRIPTION OF FIGURES

The above and other aspects of the present disclosure will become more apparent from the description of exemplary embodiments, taken in conjunction with the accompanying drawings.
Figure 1 is a schematic diagram illustrating an exemplary electron beam assessment apparatus.
Figure 2 is a schematic diagram illustrating an exemplary multi-beam electron-optical device that is part of the exemplary electron beam assessment apparatus of Figure 1.
Figure 3 is a schematic diagram of an exemplary electron-optical device comprising a collimator element array and a scan-deflector array that is part of the exemplary electron beam assessment apparatus of Figure 1.
Figure 4 is a schematic diagram of an exemplary electron-optical device array comprising the electron-optical devices of Figure 3.
Figure 5 is a schematic diagram of an alternative exemplary electron-optical device that is part of the exemplary electron beam assessment apparatus of Figure 1.
Figure 6 is a schematic diagram of an exemplary electron-optical assembly that is part of the electron-optical devices of Figures 3, 4 and 5.
Figure 7 is a schematic diagram of an exemplary electron-optical assembly that is part of the electron-optical devices of Figures 3, 4 and 5.
Figure 8 is a schematic diagram of an exemplary electron-optical assembly that is part of the electron-optical devices of Figures 3, 4 and 5.
Figure 9 is a schematic diagram of an exemplary electron-optical assembly that is part of the electron-optical devices of Figures 3, 4 and 5.
Figure 10 is a schematic view of an alignment fiducial.
Figure 11 is a schematic view of alignment fiducials on opposite sides of a beam area.

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

### DETAILED DESCRIPTION

The reduction of the physical size of devices, and enhancement of the computing power of electronic devices, may be accomplished by significantly increasing the packing density of circuit components such as transistors, capacitors, diodes, etc. on an IC chip. This has been enabled by increased resolution enabling yet smaller structures to be made. Semiconductor IC manufacturing is a complex and time-consuming process, with hundreds of individual steps. An error in any step of the process of manufacturing an IC chip has the potential to adversely affect the functioning of the final product. Just one defect could cause device failure. It is desirable to improve the overall yield of the process. For example, to obtain a 75% yield for a 50-step process (where a step may indicate the number of layers formed on a wafer), each individual step must have a yield greater than 99.4%,. If an individual step has a yield of 95%, the overall process yield would be as low as 7-8%.

Maintaining a high substrate (i.e. wafer) throughput, defined as the number of substrates processed per hour, is also desirable. High process yield and high substrate throughput may be impacted by the presence of a defect. This is especially true if operator intervention is required for reviewing the defects. High throughput detection and identification of micro and nano-scale defects by assessment systems (such as a Scanning Electron Microscope ('SEM')) is desirable for maintaining high yield and low cost for IC chips.

A scanning electron microscope comprises a scanning device and a detector apparatus. The scanning device comprises an illumination apparatus that comprises an electron source, for generating primary electrons, and a projection apparatus for scanning a target, such as a substrate, with one or more focused beams of primary electrons. The primary electrons interact with the target and generate interaction products, such as signal particles e.g. secondary electrons and/or backscattered electrons. Secondary electrons may be considered to have an energy of up to 50eV. Backscatter electrons, although having an energy spectrum from substantially zero to the energy of the maximum of the charged particle device, are conventionally set to electrons (or signal electrons) having an energy exceeding 50eV. The detection apparatus captures the signal particles (e.g. secondary electrons and/or backscattered electrons) from the target as the target is scanned so that the scanning electron microscope may create an image of the scanned area of the target. A design of an assessment apparatus embodying these scanning electron microscope features may have a single beam. For higher throughput such as for assessment, some designs of apparatus use multiple focused beams, i.e. a multi-beam, of primary electrons. The component beams of the multi-beam may be referred to as sub-beams or beamlets. A multi-beam may scan different parts of a target simultaneously. A multi-beam assessment apparatus may therefore assess a target much quicker, e.g. by moving the target at a higher speed, than a single-beam assessment apparatus.

In a multi-beam assessment apparatus, the paths of some of the primary electron beams are displaced away from the central axis, i.e. a mid-point of the primary electron-optical axis (also referred to herein as the charged particle axis), of the scanning device. To ensure all the electron beams arrive at the sample surface with substantially the same angle of incidence, sub-beam paths with a greater radial distance from the central axis need to be manipulated to move through a greater angle than the sub-beam paths with paths closer to the central axis. This stronger manipulation may cause aberrations that cause the resulting image to be blurry and out-of-focus. An example is spherical aberrations which bring the focus of each sub-beam path into a different focal plane. In particular, for sub-beam paths that are not on the central axis, the change in focal plane in the sub-beams is greater with the radial displacement from the central axis. Such aberrations and de-focus effects may remain associated with the signal particles (e.g. secondary electrons) from the target when they are detected, for example the shape and size of the spot formed by the sub-beam on the target will be affected. Such aberrations therefore degrade the quality of resulting images that are created during assessment.

An implementation of a known multi-beam assessment apparatus is described below.

The Figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to electron-optics, it is appreciated that the embodiments are not used to limit the present disclosure to specific charged particles. References to electrons, and items referred with reference to electrons, throughout the present document may therefore be more generally be considered to be references to charged particles, and items referred to in reference to charged particles, with the charged particles not necessarily being electrons.

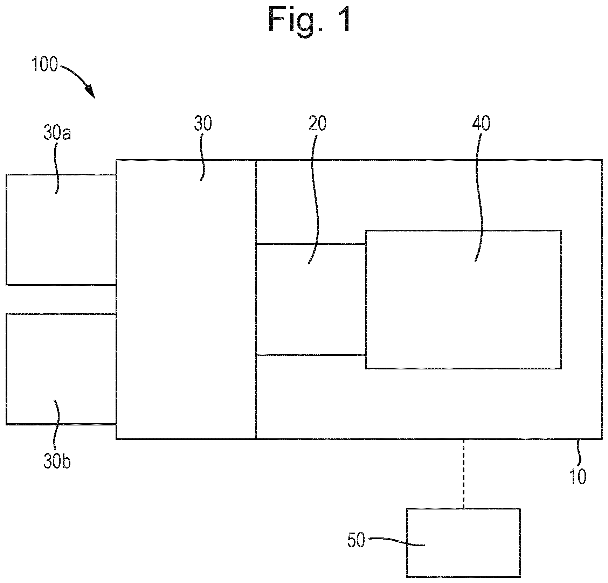

Reference is now made to Figure 1, which is a schematic diagram illustrating an exemplary assessment apparatus 100, which may be a type of an electron beam assessment apparatus or which may be referred to as an electron-optical apparatus. The assessment apparatus 100 of Fig. 1 includes a vacuum chamber 10, a load lock chamber 20, an electron-optical device 40 (also known as an electron beam device or an electron beam device), an equipment front end module (EFEM) 30 and a controller 50. The electron-optical device 40 may be within the vacuum chamber 10. The assessment apparatus 100 may comprise a motorized or actuatable stage.

The EFEM 30 includes a first loading port 30a and a second loading port 30b. The EFEM 30 may include additional loading port(s). The first loading port 30a and second loading port 30b may, for example, receive substrate front opening unified pods (FOUPs) that contain substrates (e.g., semiconductor substrates or substrates made of other material(s)) or targets to be assessed (substrates, wafers and samples are collectively referred to as "targets" hereafter). One or more robot arms (not shown) in EFEM 30 transport the targets to load lock chamber 20.

The load lock chamber 20 is used to remove the gas around a target. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. The main chamber 10 is connected to a main chamber vacuum pump system (not shown). The main chamber vacuum pump system removes gas molecules in the main chamber 10 so that the pressure around the target reaches a second pressure lower than the first pressure. After reaching the second pressure, the target is transported to the electron-optical device 40 by which it may be assessed. An electron-optical device 40 may be configured to project either a single beam or a multi-beam.

The controller 50 is electronically connected to the electron-optical device 40. The controller 50 may be a processor (such as a computer) configured to control the charged particle beam assessment apparatus 100. The controller 50 may also include a processing circuitry configured to execute various signal and image processing functions. While the controller 50 is shown in Figure 1 as being outside of the structure that includes the main chamber 10, the load lock chamber 20, and the EFEM 30, it is appreciated that the controller 50 may be part of the structure. The controller 50 may be located in one of the component elements of the charged particle beam assessment apparatus or it may be distributed over at least two of the component elements. While the present disclosure provides examples of main chamber 10 housing an electron beam assessment apparatus, it should be noted that aspects of the disclosure in their broadest sense are not limited to a chamber housing an electron-optical device. Rather, it is appreciated that the foregoing principles may also be applied to other apparatuses and other arrangements of apparatus that operate under the second pressure.

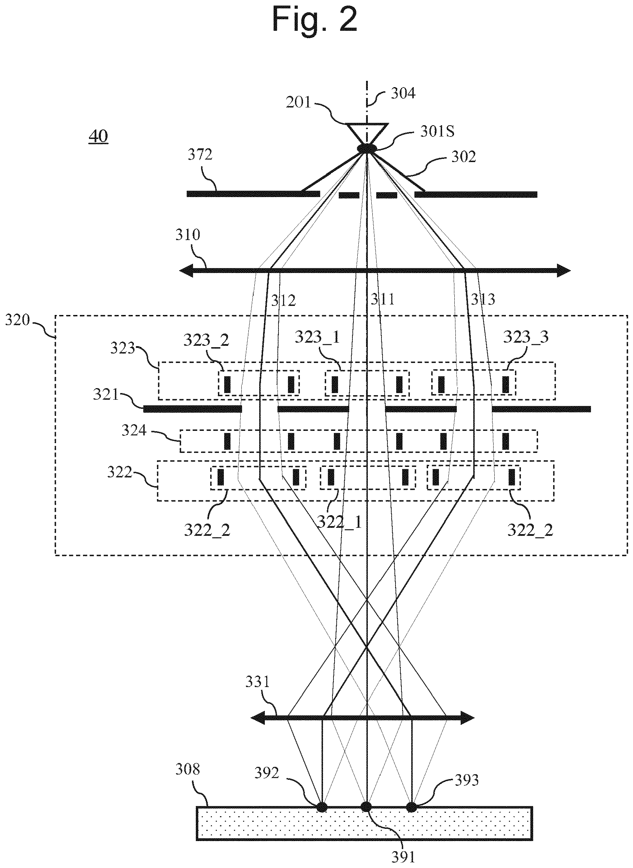

Reference is now made to Figure 2, which is a schematic diagram of an exemplary multi-beam electron-optical device 40 of an assessment apparatus, e.g. the assessment apparatus 100 of Figure 1. In an alternative embodiment the assessment apparatus 100 is a single-beam assessment apparatus. The electron-optical device 40 may comprise an electron source 201, a beam former array 372 (also known as a gun aperture plate, a coulomb aperture array or a pre-sub-beam-forming aperture array), a condenser lens 310, a source converter (or micro-optical array) 320, an objective lens 331, and a target 308. In an embodiment the condenser lens 310 is magnetic. (A single beam assessment apparatus may have the same features as a multibeam assessment apparatus except electron-optical components with an array apertures 372, 320 may have a single aperture. The source converter 320 may be replaced with a number of electron-optical components along the beam path). The target 308 may be supported by a support on a stage. The stage may be motorized. The stage moves so that the target 308 is scanned by the incidental electrons. The electron source 201, the beam former array 372, the condenser lens 310 may be the components of an illumination apparatus comprised by the electron-optical device 40. The source converter 320 (also known as a source conversion unit), described in more detail below, and the objective lens 331 may be the components of a projection apparatus comprised by the electron-optical device 40.

The electron source 201, the beam former array 372, the condenser lens 310, the source converter 320, and the objective lens 331 are aligned with a primary electron-optical axis 304 of the electron-optical device 40. The electron source 201 may generate a primary beam 302 generally along the electron-optical axis 304 and with a source crossover (virtual or real) 301S. During operation, the electron source 201 is configured to emit electrons. The electrons are extracted or accelerated by an extractor and/or an anode to form the primary beam 302.

The beam former array 372 cuts the peripheral electrons of primary electron beam 302 to reduce a consequential Coulomb effect. The primary-electron beam 302 may be trimmed into a specified number of sub-beams, such as three sub-beams 311, 312 and 313, by the beam former array 372. It should be understood that the description is intended to apply to an electron-optical device 40 with any number of sub-beams such as one, two or more than three. The beam former array 372, in operation, is configured to block off peripheral electrons to reduce the Coulomb effect. The Coulomb effect may enlarge the size of each of the probe spots 391, 392, 393 and therefore deteriorate assessment resolution. The beam former array 372 reduces aberrations resulting from Coulomb interactions between electrons projected in the beam. The beam former array 372 may include multiple openings for generating primary sub-beams even before the source converter 320.

The source converter 320 is configured to convert the beam (including sub-beams if present) transmitted by the beam former array 372 into the sub-beams that are projected towards the target 308. In an embodiment the source converter is a unit. Alternatively, the term source converter may be used simply as a collective term for the group of components that form the beamlets from the sub-beams.

As shown in Figure 2, in an embodiment the electron-optical device 40 comprises a beam-limiting aperture array 321 with an aperture pattern (i.e. apertures arranged in a formation) configured to define the outer dimensions of the beamlets (or sub-beams) projected towards the target 308. In an embodiment the beam-limiting aperture array 321 is part of the source converter 320. In an alternative embodiment the beam-limiting aperture array 321 is part of the system up-beam of the main device. In an embodiment, the beam-limiting aperture array 321 divides one or more of the sub-beams 311, 312, 313 into beamlets such that the number of beamlets projected towards the target 308 is greater than the number of sub-beams transmitted through the beam former array 372. In an alternative embodiment, the beam-limiting aperture array 321 keeps the number of the sub-beams incident on the beam-limiting aperture array 321, in which case the number of sub-beams may equal the number of beamlets projected towards the target 308.

As shown in Figure 2, in an embodiment the electron-optical device 40 comprises a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams 311, 312, and 313 onto the beam-limiting aperture array 321.

The electron-optical device 40 may also include an image-forming element array 322 with image-forming deflectors 322_1, 322_2, and 322_3. There is a respective deflector 322_1, 322_2, and 322_3 associated with the path of each beamlet. The deflectors 322_1, 322_2, and 322_3 are configured to deflect the paths of the beamlets towards the electron-optical axis 304. The deflected beamlets form virtual images (not shown) of source crossover 301S. In the current embodiment, these virtual images are projected onto the target 308 by the objective lens 331 and form probe spots 391, 392, 393 thereon. The electron-optical device 40 may also include an aberration compensator array 324 configured to compensate aberrations that may be present in each of the sub-beams. In an embodiment the aberration compensator array 324 comprises a lens configured to operate on a respective beamlet. The lens may take the form or an array of lenses. The lenses in the array may operate on a different beamlet of the multi-beam. The aberration compensator array 324 may, for example, include a field curvature compensator array (not shown) for example with micro-lenses. The field curvature compensator and micro-lenses may, for example, be configured to compensate the individual sub-beams for field curvature aberrations evident in the probe spots, 391, 392, and 393. The aberration compensator array 324 may include an astigmatism compensator array (not shown) with micro-stigmators. The micro-stigmators may, for example, be controlled to operate on the sub-beams to compensate astigmatism aberrations that are otherwise present in the probe spots, 391, 392, and 393.

The source converter 320 may be an electron-optical assembly comprising a stack 700 as herein described. The source converter 320 may comprise a pre-bending deflector array 323,a beam-limiting aperture array 321, an aberration compensator array 324, and an image-forming element array 322. The pre-bending deflector array 323 may comprise pre-bending deflectors 323_1, 323_2, and 323_3 to bend the sub-beams 311, 312, and 313 respectively. The pre-bending deflectors 323_1, 323_2, and 323_3 may bend the path of the sub-beams onto the beam-limiting aperture array 321. In an embodiment, the pre-bending micro-deflector array 323 may be configured to bend the sub-beam path of sub-beams towards the orthogonal of the plane of the beam-limiting aperture array 321. In an alternative embodiment the condenser lens 310 may adjust the path direction of the sub-beams onto the beam-limiting aperture array 321. The condenser lens 310 may, for example, focus (collimate) the three sub-beams 311, 312, and 313 to become substantially parallel beams along primary electron-optical axis 304, so that the three sub-beams 311, 312, and 313 incident substantially perpendicularly onto source converter 320, which may correspond to the beam-limiting aperture array 321. In such alternative embodiment the pre-bending deflector array 323 may not be necessary.

The image-forming element array 322, the aberration compensator array 324, and the pre-bending deflector array 323 may comprise multiple layers of sub-beam manipulating devices, some of which may be in the form or arrays, for example: micro-deflectors, micro-lenses, or micro-stigmators. Beam paths may be manipulated rotationally. Rotational corrections may be applied by a magnetic lens. Rotational corrections may additionally, or alternatively, be achieved by an existing magnetic lens such as the condenser lens arrangement.

In the current example of the electron-optical device 40, the beamlets are respectively deflected by the deflectors 322_1, 322_2, and 322_3 of the image-forming element array 322 towards the electron-optical axis 304. It should be understood that the beamlet path may already correspond to the electron-optical axis 304 prior to reaching deflector 322_1, 322_2, and 322_3.

The objective lens 331 focuses the beamlets onto the surface of the target 308, i.e., it projects the three virtual images onto the target surface. The three images formed by three sub-beams 311 to 313 on the target surface form three probe spots 391, 392 and 393 thereon. In an embodiment the deflection angles of sub-beams 311 to 313 are adjusted to pass through or approach the front focal point of objective lens 331 to reduce or limit the off-axis aberrations of three probe spots 391 to 393. In an arrangement the objective lens 331 is magnetic. Although three beamlets are mentioned, this is by way of example only. There may be any number of beamlets.

A manipulator is configured to manipulate one or more beams of charged particles. The term manipulator encompasses a deflector, a lens and an aperture. The pre-bending deflector array 323, the aberration compensator array 324 and the image-forming element array 322 may individually or in combination with each other, be referred to as a manipulator array, because they manipulate one or more sub-beams or beamlets of charged particles. The lens and the deflectors 322_1, 322_2, and 322_3 may be referred to as manipulators because they manipulate one or more sub-beams or beamlets of charged particles.

In an embodiment a beam separator (not shown) is provided. The beam separator may be down-beam of the source converter 320. The beam separator may be, for example, a Wien filter comprising an electrostatic dipole field and a magnetic dipole field. The beam separator may be up-beam of the objective lens 331. The beam separator may be positioned between adjacent sections of shielding in the direction of the beam path. The inner surface of the shielding may be radially inward of the beam separator. Alternatively, the beam separator may be within the shielding. In operation, the beam separator may be configured to exert an electrostatic force by electrostatic dipole field on individual electrons of sub-beams. In an embodiment, the electrostatic force is equal in magnitude but opposite in direction to the magnetic force exerted by the magnetic dipole field of beam separator on the individual primary electrons of the sub-beams. The sub-beams may therefore pass at least substantially straight through the beam separator with at least substantially zero deflection angle. The direction of the magnetic force depends on the direction of motion of the electrons while the direction of the electrostatic force does not depend on the direction of motion of the electrons. So because the secondary electrons and backscattered electrons (or signal electrons) generally move in an opposite direction compared to the primary electrons, the magnetic force exerted on the secondary electrons and backscattered electrons (or signal particles) will no longer cancel the electrostatic force and as a result the secondary electrons and backscattered electrons moving through the beam separator will be deflected away from the electron-optical axis 304.

In an embodiment a secondary device (not shown) is provided comprising detection elements for detecting corresponding secondary charged particle beams. On incidence of secondary beams with the detection elements, the elements may generate corresponding intensity signal outputs. The outputs may be directed to an image processing system (e.g., controller 50). Each detection element may comprise an array which may be in the form of a grid. The array may have one or more pixels; each pixel may correspond to an element of the array. The intensity signal output of a detection element may be a sum of signals generated by all the pixels within the detection element.

In an embodiment a secondary projection apparatus and its associated electron detection device (not shown) are provided. The secondary projection apparatus and its associated electron detection device may be aligned with a secondary electron-optical axis of the secondary device. In an embodiment the beam separator is arranged to deflect the path of the secondary electron beams towards the secondary projection apparatus. The secondary projection apparatus subsequently focuses the path of secondary electron beams onto a plurality of detection regions of the electron detection device. The secondary projection apparatus and its associated electron detection device may register and generate an image of the target 308 using the secondary electrons or backscattered electrons (or signal particles).

Such a Wien filter, a secondary device and/or a secondary projection apparatus may be provided in a single beam assessment apparatus. Additionally and/or alternatively a detection device may be present down beam of the objective lens, for example facing the sample during operation. In an alternative arrangement a detector device is positioned along the path of the charged particle beam towards the sample. Such an arrangement does not have a Wien filter, a secondary device and a secondary projection apparatus. The detection device may be positioned at one or more positions along the path of the charged particle beam path towards the sample, such as facing the sample during operation, for example around the path of the charged particle beam. Such a detector device may have an aperture and may be annular. The different detector devices may be positioned along the path of the charged particle to detect signal particles having different characteristics. The electron-optical elements along the path of the charged particle beam, which may include one or more electrostatic plates with an aperture for the path of the charged particle beam, may be arranged and controlled to focus the signal particles of different respective characteristics to a respective detector device at different positions along the path of charged particle beams. Such electro-static plates may be arranged in series of two or more adjoining plates along the path of the charged particle beam.

In an embodiment the assessment apparatus 100 comprises a single source.

Any element or collection of elements may be replaceable or field replaceable within the electron-optical device. The one or more electron-optical components in the electron-optical device, especially those that operate on sub-beams or generate sub-beams, such as aperture arrays and manipulator arrays may comprise one or more microelectromechanical systems (MEMS). The pre-bending deflector array 323 may be a MEMS. MEMS are miniaturized mechanical and electromechanical elements that are made using microfabrication techniques. In an embodiment the electron-optical device 40 comprises apertures, lenses and deflectors formed as MEMS. In an embodiment, the manipulators such as the lenses and deflectors 322_1, 322_2, and 322_3 are controllable, passively, actively, as a whole array, individually or in groups within an array, so as to control the beamlets of charged particles projected towards the target 308.

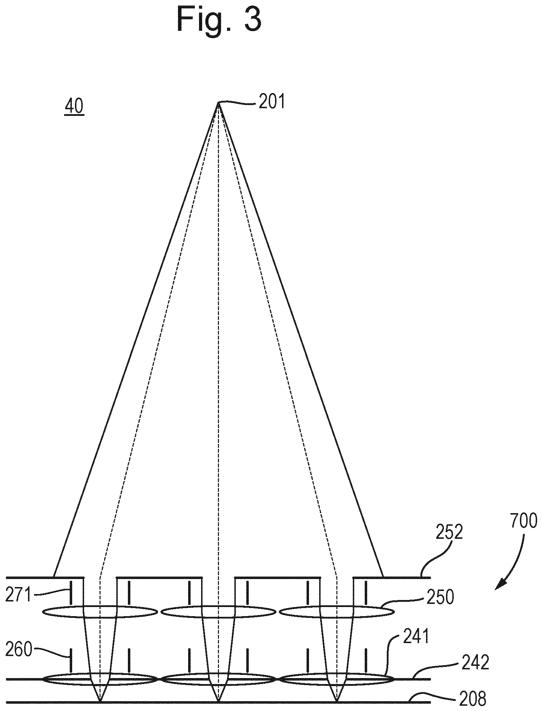

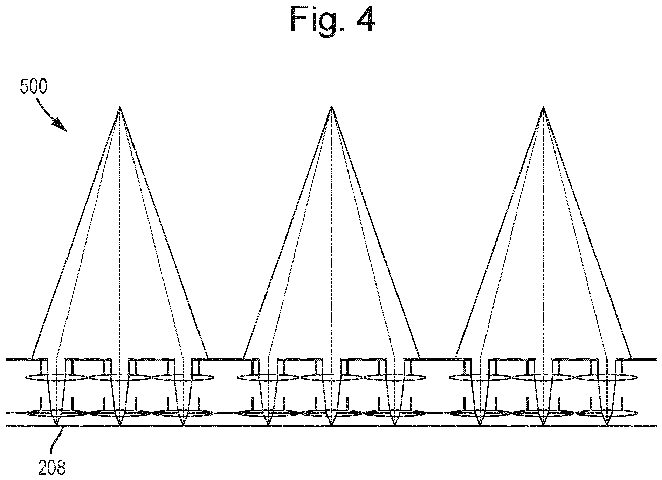

In an embodiment the electron-optical device 40 may comprise alternative and/or additional components on the charged particle path, such as lenses and other components some of which have been described earlier with reference to Figures. 1 and 2. Examples of such arrangements are shown in Figures 3 and 4 which are described in further detail later. In particular, embodiments include an electron-optical device 40 that divides a charged particle beam from a source into a plurality of sub-beams. A plurality of respective objective lenses may project the sub-beams onto a sample. In some embodiments, a plurality of condenser lenses is provided up-beam from the objective lenses. The condenser lenses focus each of the sub-beams to an intermediate focus up-beam of the objective lenses. In some embodiments, collimators are provided up-beam from the objective lenses. Correctors may be provided to reduce focus error and/or aberrations. In some embodiments, such correctors are integrated into or positioned directly adjacent to the objective lenses. Where condenser lenses are provided, such correctors may additionally, or alternatively, be integrated into, or positioned directly adjacent to, the condenser lenses and/or positioned in, or directly adjacent to, the intermediate foci. A detector is provided to detect charged particles emitted by the sample. The detector may be integrated into the objective lens. The detector may be on the bottom surface of the objective lens so as to face a sample in use. The detector may comprise an array which may correspond to the array of the beamlets of the multi-beam arrangement. The detectors in the detector array may generate detection signals that may be associated with the pixels of a generated image. The condenser lenses, objective lenses and/or detector may be formed as MEMS and/or CMOS devices, for example a CMOS device made by using MEMS processing.

Figure 3 is a schematic diagram of another design of an exemplary electron-optical device 40. The electron-optical device 40 may comprise a source 201 and one or more electron-optical assemblies. Alternatively, the assessment apparatus 100 that comprises the electron-optical device 40 may comprise the source 201. The electron-optical device 40 may comprise an upper beam limiter 252, a collimator element array 271, a control lens array 250, a scan deflector array 260, an objective lens array 241, a beam shaping limiter 242 and a detector array. The source 201 provides a beam of charged particles (e.g. electrons). The multi-beam focused on the sample 208 is derived from the beam provided by the source 201. Sub-beams may be derived from the beam, for example, using a beam limiter defining an array of beam-limiting apertures. The source 201 is desirably a high brightness thermal field emitter with a good compromise between brightness and total emission current.

The upper beam limiter 252 defines an array of beam-limiting apertures. The upper beam limiter 252 may be referred to as an upper beam-limiting aperture array or up-beam beam-limiting aperture array. The upper beam limiter 252 may comprise a plate (which may be a plate-like body) having a plurality of apertures. The upper beam limiter 252 forms the sub-beams from the beam of charged particles emitted by the source 201. Portions of the beam other than those contributing to forming the sub-beams may be blocked (e.g. absorbed) by the upper beam limiter 252 so as not to interfere with the sub-beams down-beam. The upper beam limiter 252 may be referred to as a sub-beam defining aperture array.

The collimator element array 271 is provided down-beam of the upper beam limiter. Each collimator element collimates a respective sub-beam. The collimator element array 271 may be spatially compact which can be achieved using MEMS manufacturing techniques. In some embodiments, exemplified in Figure 3, the collimator element array 271 is the first deflecting or focusing electron-optical array element in the beam path down-beam of the source 201. In another arrangement, the collimator may take the form, wholly or partially, of a macro-collimator. Such a macro-collimator may be up beam of the upper beam limiter 252 so it operates on the beam from the source before generation of the multi-beam. A magnetic lens may be used as the macro-collimator.

Down-beam of the collimator element array there is the control lens array 250. The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). The control lens array 250 is positioned up-beam of the objective lens array 241. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams. Although the control lens array 241 may be indistinct from and part of the objective lens array 250, in this description the control lens array 250 is considered to be distinct and separate from the objective lens array 241.

As mentioned, the control lens array 250 is associated with the objective lens array 241. As described above, the control lens array 250 may be considered as providing electrodes additional to the electrodes 242, 243 of the objective lens array 241 for example as part of an objective lens array assembly. The additional electrodes of the control lens array 250 allow further degrees of freedom for controlling the electron-optical parameters of the sub-beams. In an embodiment the control lens array 250 may be considered to be additional electrodes of the objective lens array 241 enabling additional functionality of the respective objective lenses of the objective lens array 241. In an arrangement such electrodes may be considered part of the objective lens array providing additional functionality to the objective lenses of the objective lens array 241. In such an arrangement, the control lens is considered to be part of the corresponding objective lens, even to the extent that the control lens is only referred to as being a part of the objective lens for example in terms of providing one more extra degrees of freedom to the objective lens.

For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. As described above, lens arrays may instead comprise multiple plates with apertures.

The scan-deflector array 260 comprising a plurality of scan deflectors may be provided. The scan-deflector array 260 may be formed using MEMS manufacturing techniques. Each scan deflector scans a respective sub-beam over the sample 208. The scan-deflector array 260 may thus comprise a scan deflector for each sub-beam. Each scan deflector may deflect the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). In an embodiment, the scanning deflectors described in EP2425444, which document is hereby incorporated by reference in its entirety specifically in relation to scan deflectors, may be used to implement the scan-deflector array 260. A scan-deflector array 260 (e.g. formed using MEMS manufacturing techniques as mentioned above) may be more spatially compact than a macro scan deflector. In another arrangement, a macro scan deflector may be used up beam of the upper beam limiter 252. Its function may be similar or equivalent to the scan-deflector array although it operates on the beam from the source before the beamlets of the multi-beam are generated.

The objective lens array 241 comprising a plurality of objective lenses is provided to direct the sub-beams onto the sample 208. Each objective lens comprises at least two electrodes (e.g. two or three electrodes) connected to respective potential sources. The objective lens array 241 may comprise two or more (e.g. three) plate electrode arrays connected to respective potential sources. Each objective lens formed by the plate electrode arrays may be a micro-lens operating on a different sub-beam. Each plate defines a plurality of apertures (which may also be referred to as holes). The position of each aperture in a plate corresponds to the position of a corresponding aperture (or apertures) in the other plate (or plates). The corresponding apertures define the objective lenses and each set of corresponding apertures therefore operates in use on the same sub-beam in the multi-beam. Each objective lens projects a respective sub-beam of the multi-beam onto a sample 208.

An objective lens array 241 having only two electrodes can have lower aberration than an objective lens array 241 having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beam. Such additional electrodes may be considered to form the control lens array 250. A benefit of a two electrode lens over an Einzel lens is that the energy of an incoming beam is not necessarily the same as an outgoing beam. Beneficially the potential differences on such a two electrode lens array enables it to function as either an accelerating or a decelerating lens array.

The objective lens array may form part of an objective lens array assembly along with any or all of the scan-deflector array 260, control lens array 250 and collimator element array 271. The objective lens array assembly may further comprise the beam shaping limiter 242. The beam shaping limiter 242 defines an array of beam-limiting apertures. The beam shaping limiter 242 may be referred to as a lower beam limiter, lower beam-limiting aperture array or final beam-limiting aperture array. The beam shaping limiter 242 may comprise a plate (which may be a plate-like body) having a plurality of apertures. The beam shaping limiter 242 is down-beam from at least one electrode (optionally from all electrodes) of the control lens array 250. In some embodiments, the beam shaping limiter 242 is down-beam from at least one electrode (optionally from all electrodes) of the objective lens array 241.

In an arrangement, the beam shaping limiter 242 is structurally integrated with an electrode 302 of the objective lens array 241. Desirably, the beam shaping limiter 242 is positioned in a region of low electrostatic field strength. Each of the beam-limiting apertures is aligned with a corresponding objective lens in the objective lens array 241. The alignment is such that a portion of a sub-beam from the corresponding objective lens can pass through the beam-limiting aperture and impinge onto the sample 208. The apertures of the beam shaping limiter 242 may have a smaller diameter than the apertures of at least one of the objective lens array 242, the control lens array 250, the detector array 240 and the upper beam limiter array 252. Each beam-limiting aperture has a beam limiting effect, allowing only a selected portion of the sub-beam incident onto the beam shaping limiter 242 to pass through the beam-limiting aperture. The selected portion may be such that only a portion of the respective sub-beam passing through a central portion of respective apertures in the objective lens array reaches the sample. The central portion may have a circular cross-section and/or be centered on a beam axis of the sub-beam.

In an embodiment, the electron-optical device 40 is configured to control the objective lens array assembly (e.g. by controlling potentials applied to electrodes of the control lens array 250) so that a focal length of the control lenses is larger than a separation between the control lens array 250 and the objective lens array 241. The control lens array 250 and objective lens array 241 may thus be positioned relatively close together, with a focusing action from the control lens array 250 that is too weak to form an intermediate focus between the control lens array 250 and objective lens array 241. The control lens array and the objective lens array operate together to for a combined focal length to the same surface. Combined operation without an intermediate focus may reduce the risk of aberrations. In other embodiments, the objective lens array assembly may be configured to form an intermediate focus between the control lens array 250 and the objective lens array 241.

An electric power source may be provided to apply respective potentials to electrodes of the control lenses of the control lens array 250 and the objective lenses of the objective lens array 241.

The provision of a control lens array 250 in addition to an objective lens array 241 provides additional degrees of freedom for controlling properties of the sub-beams. The additional freedom is provided even when the control lens array 250 and objective lens array 241 are provided relatively close together, for example such that no intermediate focus is formed between the control lens array 250 and the objective lens array 241. The control lens array 250 may be used to optimize a beam opening angle with respect to the demagnification of the beam and/or to control the beam energy delivered to the objective lens array 241. The control lens may comprise two or three or more electrodes. If there are two electrodes then the demagnification and landing energy are controlled together. If there are three or more electrodes the demagnification and landing energy can be controlled independently. Note, the most down-beam electrode of the control lens array 250 may be the most up-beam electrode of the objective lens array 241. That is the control lens array 250 and the objective lens array 241 may share an electrode. The shared electrode provides different lensing effects for each lens, each lensing effect with respect to one of its two opposing surfaces (i.e. up beam surface and down beam surface). The control lenses may thus be configured to adjust the demagnification and/or beam opening angle and/or the landing energy on the substrate of respective sub-beams (e.g. using the electric power source to apply suitable respective potentials to the electrodes of the control lenses and the objective lenses). This optimization can be achieved without having an excessively negative impact on the number of objective lenses and without excessively deteriorating aberrations of the objective lenses (e.g. without decreasing the strength of the objective lenses). Use of the control lens array enables the objective lens array to operate at its optimal electric field strength. Note that it is intended that the reference to demagnification and opening angle is intended to refer to variation of the same parameter. In an ideal arrangement the product of a range of demagnification and the corresponding opening angles is constant. However, the opening angle may be influenced by the use of an aperture.

In an embodiment, the landing energy can be controlled to a desired value in a predetermined range, e.g. from 1000 eV to 5000 eV. Desirably, the landing energy is primarily varied by controlling the energy of the electrons exiting the control lens. The potential differences within the objective lenses are preferably kept constant during this variation so that the electric field within the objective lens remains as high as possible. The potentials applied to the control lens in addition may be used to optimize the beam opening angle and demagnification. The control lens can function to change the demagnification in view of changes in landing energy. Desirably, each control lens comprises three electrodes so as to provide two independent control variables. For example, one of the electrodes can be used to control magnification while a different electrode can be used to independently control landing energy. Alternatively each control lens may have only two electrodes. When there are only two electrodes, one of the electrodes may need to control both magnification and landing energy.

The detector array (not shown) is provided to detect charged particles emitted from the sample 208. The detected charged particles may include any of the charged particles (e.g. signal particles) detected by a scanning electron microscope, including secondary and/or backscattered electrons from the sample 208. The detector may be an array providing the surface of the electron-optical device facing the sample 208, e.g. the bottom surface of the electron-optical device. Alternative the detector array be up beam of the bottom surface or example in or up beam of the objective lens array or the control lens array. The elements of the detector array may correspond to the beamlets of the multi-beam arrangement. The signal generated by detection of an electron by an element of the array be transmitted to a processor for generation of an image. The signal may correspond to a pixel of an image.

In other embodiments both a macro scan deflector and the scan-deflector array 260 are provided. In such an arrangement, the scanning of the sub-beams over the sample surface may be achieved by controlling the macro scan deflector and the scan-deflector array 260 together, preferably in synchronization.

In an embodiment, as exemplified in Figure 4, an electron-optical device array 500 is provided. The array 500 may comprise a plurality of any of the electron-optical devices described herein. Each of the electron-optical devices focuses respective multi-beams simultaneously onto different regions of the same sample. Each electron-optical device may form sub-beams from a beam of charged particles from a different respective source 201. Each respective source 201 may be one source in a plurality of sources 201. At least a subset of the plurality of sources 201 may be provided as a source array. The source array may comprise a plurality of sources 201 provided on a common substrate. The focusing of plural multi-beams simultaneously onto different regions of the same sample allows an increased area of the sample 208 to be processed (e.g. assessed) simultaneously. The electron-optical devices in the array 500 may be arranged adjacent to each other so as to project the respective multi-beams onto adjacent regions of the sample 208.

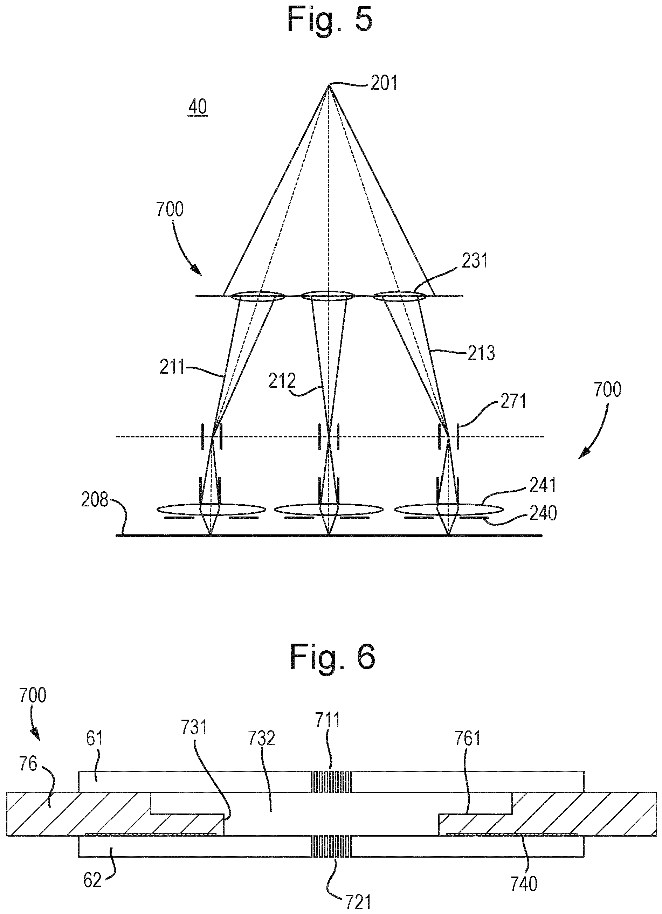

Any number of electron-optical devices may be used in the array 500. Preferably, the number of electron-optical devices is in the range of from two (2), desirably nine (9) to one hundred (100) even two hundred (200). In an embodiment, the electron-optical devices are arranged in a rectangular array or in a hexagonal array. In other embodiments, the electron-optical devices are provided in an irregular array or in a regular array having a geometry other than rectangular or hexagonal. Each electron-optical device in the array 500 may be configured in any of the ways described herein when referring to a single electron-optical device, for example as described above, especially with respect to the embodiment shown and described in reference to Fig 6. Details of such an arrangement is described in EPA 20184161.6 filed 6 July 2020 which, with respect to how the objective lens is incorporated and adapted for use in the multi-device arrangement is hereby incorporated by reference.

In the example of Figure 4 the array 500 comprises a plurality of electron-optical devices of the type described above with reference to Figure 3. Each of the electron-optical devices in this example thus comprise both a scan-deflector array 260 and a collimator element array 271. As mentioned above, the scan-deflector array 260 and collimator element array 271 are particularly well suited to incorporation into an electron-optical device array 500 because of their spatial compactness, which facilitates positioning of the electron-optical devices close to each other. This arrangement of electron-optical device may be preferred over other arrangements that use a magnetic lens as collimator. Magnetic lenses may be challenging to incorporate into an electron-optical device intended for use in a multi-device arrangement (e.g. multi-column arrangement) for example because of magnetic interference between columns.

An alternative design of multi-beam electron-optical device may have the same features as described with respect to Figure 3 expect as described below and illustrated in Figure 5. The alternative design of multi-beam electron-optical device may comprise a condenser lens array 231 upbeam of the object lens array arrangement 241, as disclosed in EP application 20158804.3 filed on 21 February 2020 which is hereby incorporated by reference so far as the description of the multi-beam device with a collimator and its components. Such a design does not require the beam shaping limiter array 242 or the upper beam limiter array 252 because a beam limiting aperture array associated with condenser lens array 231 may shape the beamlets 211, 212, 213 of the multi-beam from the beam of the source 201. The beam limiting aperture array of the condenser lens may also function as an electrode in the lens array.

The paths of the beamlets 211, 212, 213 diverge away from the condenser lens array 231. The condenser lens array 231 focuses the generated beamlets to an intermediate focus between the condenser lens array 231 and the objective lens array assembly 241 (i.e. towards the control lens array and the objective lens array). The collimator array 271 may be at the intermediate foci instead of associated with the objective lens array assembly 241.

The collimator may reduce the divergence of the diverging beamlet paths. The collimator may collimate the diverging beamlet paths so that they are substantially parallel towards the objective lens array assembly. Corrector arrays may be present in the multi-beam path, for example associated with the condenser lens array, the intermediate foci and the objective lens array assembly. The detector 240 may be integrated into the objective lens 241. The detector 240 may be on the bottom surface of the objective lens 241 so as to face a sample in use.

In an embodiment of the arrangement shown in and described with reference to Figure 5, the detector may be located in similar locations in the electron-optical device 241 as described with reference to and as shown in the electron-optical device of Figure 3. The detector 250 may be integrated into the objective lens array 241 and the control lens array 240 (when present as it is not depicted in Figure 5). The detector may have more than one detector at different positions along the paths of the sub-beams of the multi-beam, for example each array associated with a different electron-optical element, such as an electrode of the objective lens array and/or the control lens array. The objective lens array 241 and associated electron-optical elements such as the control lens array 240 may be comprised in assembly which may be a mono-lithic assembly which may be referred to as an electron-optical assembly comprising a stack 700. In an embodiment a detector 240 is associated with, or even integrated into, an electron-optical element of the stack 700. For example, the detector 240 may be on the bottom surface of a stack 700 comprising objective lenses 241. The detector 240 may be provided with an electric connection 60 as described elsewhere in this document. In a variation, the detector has a detector array positioned up beam of the objective lens array (optionally and the control lens array 240) for example up beam of the stack 700. Between the stack 700 and the detector array may be a Wien filter array that directs the charged particles beams in a down beam direction towards the sample and directs signal particles from the sample to the detector array.

An electron-optical device array may have multiple multi-beam devices of this design as described with reference to the multi-beam device of Figure 3 as shown in Figure 4. The multiple multi-beam devices may be arranged in an array of multi-beam devices. Such an arrangement is shown and described in EP Application 20158732.6 filed on 21 February 2020 which is hereby incorporated by reference with respect to the multi-device arrangement of a multi-beam apparatus featuring the design of multi-beam device disclosed with a collimator at an intermediate focus.

A further alternative design of multi-beam apparatus comprises multiple single beam devices. The single beams generated for the purposes of the invention herein described may be similar or equivalent to a multi-beam generated by a single device. Each device may have an associated detector. Such a multi-device apparatus may be arranged in an array of devices of three, four, nine, nineteen, fifty, one hundred or even two hundred devices each generating a single beam or beamlet (if of a single beam device) or a plurality of beams (if of multibeam devices). In this further alternative design the array of devices may have a common vacuum system, each device have a separate vacuum system or groups of devices are assigned different vacuum systems. Each device may have an associated detector.

The electron-optical device 40 may be a component of an assessment (e.g. inspection, metorology or metro-inspection) apparatus or part of an e-beam lithography apparatus. The multi-beam charged particle apparatus may be used in a number of different applications that include electron microscopy in general, not just scanning electron microscopy, and lithography.

The electron-optical axis 304 describes the path of charged particles through and output from the source 201. The sub-beams and beamlets of a multi-beam may all be substantially parallel to the electron-optical axis 304 at least through the manipulators or electron -optical arrays, for example of the arrangement shown and described with reference to Figure 2, unless explicitly mentioned. The electron-optical axis 304 may be the same as, or different from, a mechanical axis of the electron-optical device 40. In the context of the arrangement shown and described with respect to Figures 2 to 5, the electron-optical axis may correspond to the path of the central beam of the multibeam, for example beam 212. The beams of the multibeam are substantially parallel to each other (for example the electron-optical axis 304) between collimation (e.g. the location of the collimator array 271 which corresponds to a plane of intermediate foci (for example as shown in Figure 5) or an upper beam limiter 252) and the surface of the sample 208.

The electron-optical device 40 may comprise a stack 700 as shown in Figure 6 for operating on (e.g. manipulating) electron beamlets. For example, the stack 700 may comprise one more of (in a non-limited list): the objective lens array 241, and/or the condenser lens array 231 and/or the collimator element array 271 and/or an individual beam corrector and/or a deflector and/or a Wien filter array. In particular, the objective lens 331 and/or the condenser lens 310 and/or the control lens 250 may comprise the stack 700.

The electron-optical assembly is configured to provide a potential difference between two or more plates (or substrates). An electrostatic field is generated between the plates, which act as electrodes. The electrostatic field results in an attraction force between the two plates. The attraction force may be increased with increasing potential difference.

The stack 700 comprises a plurality of planar elements. The planar elements may comprise or be plates. In an embodiment one or more of the planar elements is an electron-optical element (e.g. electron-optical elements 61, 62 shown in Figure 6). For example, an electron-optical element may be or comprise a plate having a surface that has a voltage applied so as to provide a potential difference relative to a surface of another electron-optical element. The potential difference generates an electric field that can manipulate the electron beams. However, it is not essential for the planar elements to be elements that have a particular voltage applied to them. For example, in an embodiment, one or more of the planar elements is configured to shape or limit one or more electron beams. For example, a planar element may comprise one or more apertures for narrowing one or more respective electron beams. This function may not require the planar element to have an applied voltage.

In an embodiment the stack 700 is for an electron-optical module configured to project electrons along a beam path. In the orientation shown in Figure 6, the beam path extends substantially vertically from top to bottom. In the description below, the planar elements are referred to as electron-optical elements. However, it should be understood that any of the planar elements may not be required to be an electron-optical element and may be a different type of planar element such as a beam limiter. In an embodiment an electron-optical element comprises one or more of the planar elements.

In an embodiment at least one of the plates of the stack 700 has a thickness which is stepped such that the first electron-optical element 61 is thinner in the region corresponding to the array of apertures than another region of the first electron-optical element 61. It is advantageous to have a stepped thickness, for example with two portions of the plate having different thicknesses, because at high potential differences the plate is subjected to higher electrostatic forces which can result in bending if the plate were a consistent thickness and, for example, too thin. Bending of the plate can adversely affect beam-to-beam uniformity. Thus, a thick plate is advantageous to mitigate bending. However, if the plate is too thick in the region of the array of apertures, it can result in undesirable electron beamlet deformation. Thus, a thin plate around the array of apertures is advantageous to mitigate electron beamlet deformation. That is in a region of the plate thinner than the rest of the plate the array of apertures may be defined. The stepped thickness of the plate thus reduces the likelihood of bending, without increasing the likelihood of beamlet deformation. In an embodiment the plates have uniform thickness including in the region corresponding to the array of apertures.

The exemplary electron-optical assembly shown in Figure 6 comprises a first electron-optical element 61, a second electron-optical element 62 and a spacer (or isolator) 76. Although the terms first and second are used to differentiate the two electron-optical elements 61, 62, either of the elements may be referred to as a first or second electron-optical element and therefore such terms are exchangeable. That is in a different description of the same features the second electron-optical element may be the electron-optical element 61 that is positioned upbeam of the first electron-optical element which may be the electron-optical element 62 that is positioned downbeam of the other. These terms are used only to aid description so as to differentiate the two electron-optical elements and are not intended to be limiting. The same comment applies to all other numbered features herein unless stated to the contrary. In an embodiment the first electron-optical element 61 is or comprises an array plate. (Note the term 'array plate' is a term used to differentiate the plate from other plates referred to in the description). The second electron-optical element 62 may be or may comprise an adjoining plate, i.e. a plate adjoining the array plate. In the first electron-optical element 61, an array of apertures 711 is defined for the path of electron beamlets. The number of apertures in the array of apertures may correspond to the number of sub-beams in the multi-beam arrangement. In one arrangement there are fewer apertures than sub-beams in the multi-beam so that groups of sub-beam paths pass through an aperture. For example an aperture may extend across the multi-beam path; the aperture may be a strip or slit. In an arrangement, the apertures may be arranged in a grid (or two dimensional array) so that groups are of beams are arranged in a two dimensions array of groups of beams. The first spacer 76 is disposed between the electron-optical elements to separate the electron-optical elements. The electron-optical assembly is configured to provide a potential difference between the first electron-optical element 61 and the second electron-optical element 62.

In the second electron-optical element 62, another array of apertures 721 is defined for the path of the electron beamlets. In an embodiment one or more of the apertures (or openings) of the array of apertures 711 has a midpoint. In an embodiment one or more of the apertures (or openings) of the other array of apertures 721 has a midpoint. In an embodiment when the first electron-optical element 61 and the second electron-optical element 62 are correctly aligned, midpoints between the first electron-optical element 61 and the second electron-optical element are aligned.

In an embodiment the second electron-optical element 62 may also have a thickness which is stepped such that the second electron-optical element is thinner in the region corresponding to the array of apertures than another region of the second electron-optical element. (Alternatively the second electron-optical element 62 is substantially planar and/or has uniform thickness). Desirably, the array of apertures 721 defined in the second electron-optical element 62 has the same pattern as the array of apertures 711 defined in the first electron-optical element 61. In an arrangement the pattern of the array of apertures in the two plates may be different. For example, the number of apertures in the second electron-optical element 62 may be fewer or greater than the number of apertures in the first electron-optical element 61. In an arrangement there is a single aperture in the the second electron-optical element 62 for all the paths of the sub-beams of the multi-beam. Preferably the apertures in the first electron-optical element 61 and the second electron-optical element 62, are substantially mutually well aligned. This alignment between the apertures is in order to limit lens aberrations

The first electron-optical element 61 and the second electron-optical element 62 may each have a thickness of up to 1.5 mm at the thickest point of the plate, preferably 1 mm, more preferably 500 µm. In an arrangement, the downbeam plate (i.e., the plate closer to the sample) may have a thickness of between 200 µm and 300 µm at its thickest point. The downbeam plate preferably a thickness of between 200 µm and 150 µm at its thickest point. The upbeam plate (i.e., the plate farther from the sample) may have a thickness of up to 500 µm at its thickest point.

A coating may be provided on a surface of the first electron-optical element 61 and/or the second electron-optical element 62. Preferably both the coating is provided on the first electron-optical element 61 and the second electron-optical element 62. The coating reduces surface charging which otherwise can result in unwanted beam distortion.

The coating is configured to survive a possible electric breakdown event between the first electron-optical element 61 and the second electron-optical element 62. Preferably, a low ohmic coating is provided, and more preferably a coating of 0.5 Ohms/square or lower is provided. The coating is preferably provided on the surface of the downbeam plate. The coating is more preferably provided between at least one of the electron-optical elements and the first spacer 76. The low ohmic coating reduces undesirable surface charging of the plate.

The first electron-optical element 61 and/or the second electron-optical element 62 may comprise a low bulk resistance material, preferably a material of 1 Ohm.m or lower, optionally 0.1 Ohm.m or lower, optionally 0.01 Ohm.m or lower, optionally 0.001 Ohm.m or lower, and optionally 0.0001 Ohm.m or lower. More preferably, the first electron-optical element 61 and/or the second electron-optical element 62 comprises doped silicon. Plates having a low bulk resistance have the advantage that they are less likely to fail because the discharge current is supplied/drained via the bulk and not, for example, via the thin coating layer.

The first electron-optical element 61 comprises a first wafer. The first wafer may be etched to generate the regions having different thicknesses. The first wafer may be etched in the region corresponding to the array of apertures, such that the first electron-optical element 61 is thinner in the region corresponding to the array of apertures. For example, a first side of a wafer may be etched or both sides of the wafer may be etched to create the stepped thickness of the plate. The etching may be by deep reactive ion etching. Alternatively or additionally, the stepped thickness of the plate may be produced by laser-drilling or machining.

Alternatively, the first electron-optical element 61 may comprise a first wafer and a second wafer. The aperture array may be defined in the first wafer. The first wafer may be disposed in contact with the first spacer 76. A second wafer disposed on a surface of the first wafer in a region not corresponding to the aperture array, for example the region is distanced away from the aperture array. The first wafer and the second wafer may be joined by wafer bonding. The thickness of the first electron-optical element 61 in the region corresponding to the array of apertures may be the thickness of the first wafer. The thickness of the first electron-optical element 61 in another region, other than the region of the array of apertures, for example radially outward of the aperture array, may be the combined thickness of the first wafer and the second wafer. Thus, the first electron-optical element 61 has a stepped thickness between the first wafer and the second wafer.

One of the first electron-optical element 61 and the second electron-optical element 62 is upbeam of the other. One of the first electron-optical element 61 and the second electron-optical element 62 is negatively charged, desirably during operation, with respect to the other electron-optical element. Preferably the upbeam plate has a higher potential than the downbeam plate with respect to for example to a ground potential, the source or of the sample. The electron-optical assembly may be configured to provide a potential difference of 5 kV or greater between the first electron-optical element 61 and the second electron-optical element 62. Preferably, the potential difference is 10 kV or greater. More preferably, the potential different is 20 kV or greater, or less than 30kV or even greater than 30kV. In an embodiment the assessment apparatus 100 comprises a power supply. The power supply may be comprised in the electron-optical device 40. In an embodiment the power supply is electrically connected to one of the electro-optical elements. The power supply may be configured to apply a known voltage to the electron-optical element. In an embodiment the power supply is configured to apply a known voltage to each of a plurality of electron-optical elements. In an embodiment a plurality of power supplies are configured to apply known voltages to respective electron-optical elements.

The first spacer 76 is preferably disposed between the first electron-optical element 61 and the second electron-optical element 62 such that the opposing surfaces of the plates are co-planar with each other. The first spacer 76 has an inner edge 731 facing the path of the beamlets. The first spacer 76 may be planar with major surfaces coplanar with the first electron-optical element 61 and the second electron-optical element 62. The first spacer 76 defines a central aperture 732, for the path of the electron beamlets.

A conductive coating may be applied to the first spacer 76, for example coating 740. Preferably, a low ohmic coating is provided, and more preferably a coating of 0.5 Ohms/square or lower is provided. In an embodiment the major surfaces (i.e. the upbeam facing surface and the downbeam facing surface) of a spacer is provided with a conductive coating. The peripheral edges (i.e. side walls) of the spacer may be exposed, i.e. without a conductive coating. Alternatively, the peripheral edges may be covered with a conductive material such as metal. In an embodiment a spacer is fully covered in metal.

The coating is preferably on the surface of the space facing the negatively charged plate, which is negatively charged with respect to the other plate. The downbeam plate is preferably negatively charged with respect to the upbeam plate. The coating shall be put at the same electric potential as the negatively charged plate. The coating is preferably on the surface of the first spacer 76 facing the negatively charged plate. The coating is more preferably electrically connected to the negatively charged plate. The coating ensures that there is an electrostatic field over any possible voids in between the first spacer 76 and the negatively charged plate.

The stack 700 may comprise or be a lens assembly for manipulating electron beamlets. The lens assembly may, for example, be, or may be part of, an objective lens assembly or a condenser lens assembly. The lens assembly, such as an objective lens assembly, may further comprise an additional lens array comprising at least two plates such as a control lens array 250.

In an embodiment the electron-optical device 40 comprises an electron-optical module. The electron-optical module may be field replaceable. The electron-optical device 40 and/or the electron-optical module may comprise a stack 700 as shown in any of Figures 6-8 for operating on (e.g. manipulating) electron beamlets. In an embodiment the stack 700 comprises a plurality of electron-optical elements 61-64. The electro-optical elements may have features as described above in relation to Figure 6.

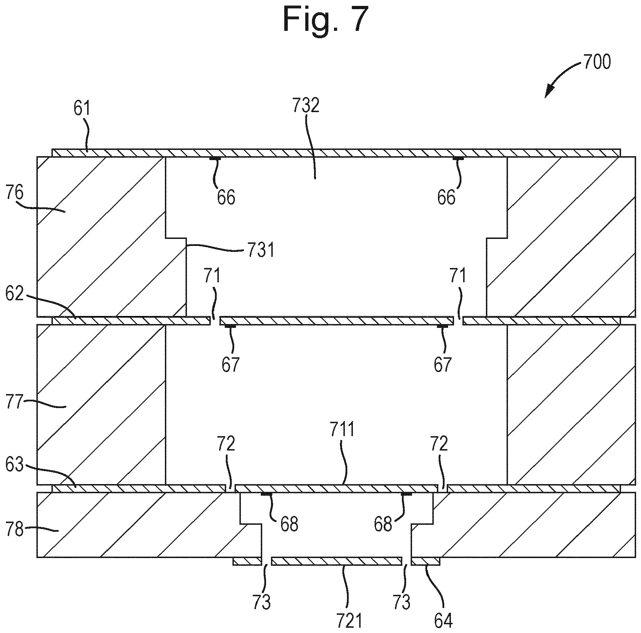

For example, as shown in Figure 6 in an embodiment the stack comprises a first electron-optical element 61 and a second electron-optical element 62. As shown in Figure 7, in an embodiment the stack comprises further electron-optical elements such as a third electron-optical element 63 and a fourth electron-optical element 64.

It is not essential for there to be four electron-optical elements 61, 64 as shown in Figure 7. For example, as shown in Figure 6 the stack may comprise only two electron-optical elements 61, 62. In alternative arrangements, the stack may comprise three electron-optical elements, five electron-optical elements or more than five electron-optical elements. In an embodiment the electron-optical elements are or comprise plates. The plates may be substantially planar. In an embodiment the electron-optical elements are arranged across the path of the electron-beams. The plane of the plates of the electron-optical elements may be substantially perpendicular to the direction parallel to the electron beam path.

In an embodiment the electron-optical elements each comprise an array of apertures. However, it is not essential for each electron-optical element to comprise an array of apertures. The apertures are for the passage of electron beams. In an embodiment one or more of the electron-optical elements comprises a single aperture for the passage of one or more electron beams. In an embodiment one or more of the electron-optical elements comprises a detector, for example for detecting electrons.

As shown in Figure 7, in an embodiment the electron-optical elements 61-64 of the stack are positioned substantially parallel to each other. Alternatively, a predetermined angle may be provided between two or more of the electron-optical elements. In an embodiment the stack is formed by stacking the electron-optical elements 61-64 relative to each other. The stack may be gradually built-up by adding one electron-optical element at a time. For example, in an embodiment the first electron-optical element 61 is provided. The second electron-optical element 62 may then be stacked relative to the first electron-optical element 61. Subsequently, a third electron-optical element 63 may be stacked relative to the first electron-optical element 61 and the second electron-optical element 62. Subsequently, a fourth electron-optical element 64 may be stacked relative to the first electron-optical element 61, the second electron-optical element 62 and the third electron-optical element 63. As will be described herein, the order of stacking the plates in the stack is desirably relevant for effective alignment between the different electron-optical elements of the stack. This applies for any numbered term herein, e.g. first, second third etc.. in reference to assembly or manufacturing of the stack.

As shown in Figure 7, in an embodiment spacers are provided between one or more pairs of adjacent electron-optical elements. The spacers may have features as described above in relation to Figure 6.

For example, in an embodiment a first spacer 76 is located between the first electron-optical element 61 and the second electron-optical element 62. In an embodiment a second spacer 77 is located between the second electron-optical element 62 and the third electron-optical element 63. In an embodiment a third spacer 78 is located between the third electron-optical element 63 and the fourth electron-optical element 64. In an embodiment the spacers are configured to mechanically support pairs of adjacent electron-optical elements relative to each other. In an embodiment the first spacer 76 is provided to control (e.g. fix) the distance between the first electron-optical element 61 and the second electron-optical element 62 in a direction parallel to the electron beam path. The thickness of the first spacer 76 may correspond to the spacing between the first electron-optical element 61 and the second electron-optical element 62 in a direction parallel to the electron beam path. In an embodiment the spacers are configured to electrically isolate pairs of adjacent electron-optical elements from each other. However, it is not essential for the spacers to provide electrical isolation. For example, when it is desired for two adjacent electron-optical elements to be at the same electrical potential, then it may not be necessary to electrically isolate them from each other. In an embodiment the spacers may be omitted from the stack.

Figure 7 schematically depicts a stack 700 of planar elements. In an embodiment one or more of the planar elements is an electron-optical element.

The electron-optical elements 61-64 are arranged across the beam path. The plane of the electron-optical elements 61-64 is desirably substantially perpendicular to the beam path.

In an embodiment the first electron-optical element 61 and the second-optical element 62 constitute a pair of electron-optical elements. One of the electron-optical elements of the pair comprises an alignment fiducial 66. An alignment fiducial may be referred to as an alignment mark or a fiducial marker. The fiducial is a point of reference for alignment of the first electron-optical element 61 relative to another component such as the second electron-optical element 62. The alignment fiducial 66 may comprise one or more visible lines and/or one or more apertures through the first electron-optical element 61. The alignment fiducial 66 may be for verifying alignment of the stack, and in particular alignment between the first electron-optical element 61 and another component such as the second electron-optical element 62.

The other of the electron-optical elements 62 comprises a monitoring aperture 71. A monitoring aperture may be referred to as an aligned aperture. The monitoring aperture may be referred to as a viewport or a port. The monitoring aperture 71 is associated with the alignment fiducial 66. The alignment fiducial 66 is visible through the monitoring aperture 71. As shown in Figure 7, in an embodiment the alignment fiducial 66 is aligned with the monitoring aperture 71. An imaginary straight line for connecting the alignment fiducial 66 and the monitoring aperture 71 is substantially perpendicular to a plane of the first electron-optical element 61 and the second electron-optical element 62. The imaginary straight line is substantially parallel to the electron beam path.

As shown in Figure 7, in an embodiment the stack comprises a plurality of pairs of adjoining electron-optical elements. Within each pair of electron-optical elements, one electron-optical element has an alignment fiducial and the other electron-optical element has a monitoring aperture. For example, in the arrangement shown in Figure 7, the second electron-optical element 62 and the third electron-optical element 63 constitutes a pair of electron-optical elements. The third electron-optical element 63 and the fourth electron-optical element 64 constitutes a pair of electron-optical elements.

As shown in Figure 7, in an embodiment, the pair of electron-optical elements are positioned (or arranged) relative to each other such that the alignment fiducial 66 and the monitoring aperture 71 are aligned with each other in a direction substantially perpendicular to a plane of the electron-optical elements 61, 62. In the view shown in Figure 7, the plane of the electron-optical elements 61, 64 extends horizontally. The first alignment fiducial 66 and the first monitor aperture 71 are aligned vertically. Similarly, the second alignment fiducial 67 and the second monitoring aperture 72 are aligned vertically. Similarly the third alignment fiducial 68 and the third monitoring aperture 73 are aligned vertically. An imaginary line that is straight and joins the first alignment fiducial 66 to the first monitoring aperture 71 is substantially perpendicular to the plane of the electron-optical elements 61,62.

In an embodiment the monitoring aperture 71 and the alignment fiducial 66 are aligned in at least two degrees for freedom, for example in at least one of the two orthogonal directions in a plane parallel to the pair of electron-optical elements 61, 62 and rotationally in the plane.

It is possible that there is a small offset between the centre of the alignment fiducial and the centre of the associated monitoring aperture. As a result, the line joining the alignment fiducial to the monitoring aperture may be slightly angled from the normal to the electron-optical elements. However, the alignment fiducial and the monitoring aperture are sufficiently aligned such that illumination light projected through the monitoring aperture and incident on the alignment fiducial can reflect directly back through the monitoring aperture.

As shown in Figure 6, one or more of the electron-optical elements 61-64, comprises an array of apertures 711, 721. The apertures are for passage through of respective electron beams. In an embodiment the apertures have a smaller dimension than the monitoring apertures in a direction parallel to the plane of the electron-optical elements. In an embodiment the apertures of the arrays of apertures 711, 721 have a diameter in a range of from about 5µm to about 100µm, and optionally from about 10µm to about 50µm. In an embodiment the monitoring apertures have a diameter in the range of from about 100µm to about 1,000µm, and optionally from about 300µm to about 600µm. In an embodiment the apertures of the array of apertures have a smaller dimension than the alignment fiducials in a direction parallel to the plane of the electron-optical elements. The apertures of the array of apertures may not be sufficiently wide (or may be insufficiently dimensioned) for the alignment fiducials to be imaged through them.

In an embodiment the stack comprises a plurality of electron-optical elements (including the pair of electron-optical elements and a further electron-optical element). Adjoining electron-optical elements of the plurality of electron-optical elements may comprise respective pairs of planar elements. The adjoining electron-optical elements may comprise an aligned alignment fiducial and a monitoring aperture.

In an embodiment one or more of the apertures (or openings) of the electron-optical elements has a midpoint. In an embodiment, on alignment of alignment fiducials of the electron-optical elements (e.g. alignment between a fiducial of one electron-optical element and a fiducial of the other electron-optical element, or alignment between a fiducial of one electron-optical element and the monitoring aperture functioning as a fiducial of the other electron-optical element), midpoints between the first electron-optical element 61 and the second electron-optical element 62 are aligned. That is the purpose of aligning the alignment fiducials with respective monitoring apertures is to align the electron-optical elements with respect to each other, in which the monitoring apertures are defined and on which the alignment fiducials are present. On alignment of electron-optical elements, the other features on and in the electron-optical elements are aligned. Such a feature is the aperture array in each plate. In an embodiment the apertures are directly in alignment with each other. In a different embodiment the pattern the array of apertures may have means the apertures do not align, but the midpoints of the different arrays of apertures are aligned.

As shown in Figure 7, in an embodiment the stack 700 comprises a further electron-optical element, namely the third electron-optical element 63, adjoining the electron-optical element, namely the second electron-optical element 62, that comprises the first monitoring aperture 71. The second electron-optical element 62 and the third electron-optical element 63 form a further pair of electron-optical elements. In an embodiment the further electron-optical element, namely the third electron-optical element 63 comprises a further monitoring aperture namely the second monitoring aperture 72.

As shown in Figure 7, in an embodiment the monitoring apertures 71, 72 are offset from each other when viewed in an direction perpendicular to the plane of the electron-optical elements. In an embodiment, each of the alignment fiducial-monitoring aperture pair is defined at different distances from the centre of the beam path (which may be a beam grid) for each element assembly step.

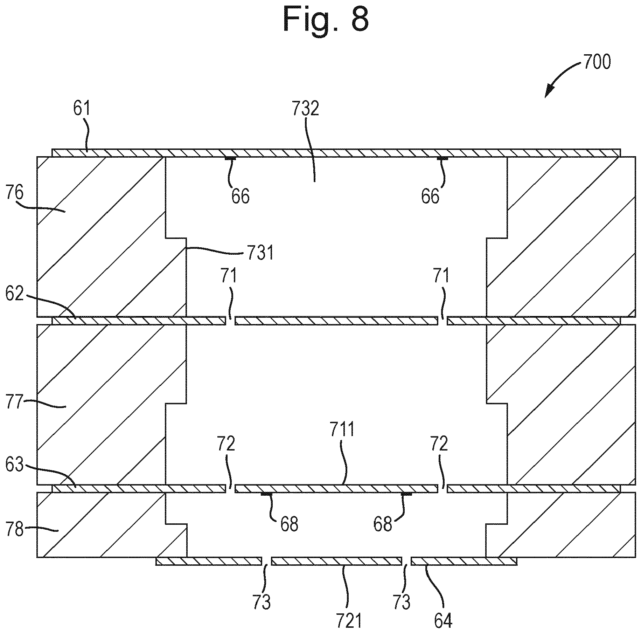

As shown in Figure 8, in an embodiment at least two of the monitoring apertures, for example the first monitoring aperture 71 and the second monitoring aperture 72 are aligned with each other in a direction substantially perpendicular to a plane of the electron-optical elements. Of course, there may be a slight misalignment (e.g. in the range of from about 0.1µm to about 2µm) of the monitoring apertures 71, 72. However, the monitoring apertures 71, 72 are sufficiently aligned with the first alignment fiducial 66 such that illumination light that projects through the monitoring aperture 71, 72 can be reflect directly off the first alignment fiducial 66 and pass back through the monitoring apertures 71, 72. In an embodiment there is a line of sight from the second monitoring aperture 72 to the first alignment fiducial 66. Any misalignment may adversely affect imaging resolution.

In Figures 7 and 8, the aspect ratio is exaggerated so that some features of the stack 700 may be shown more clearly.

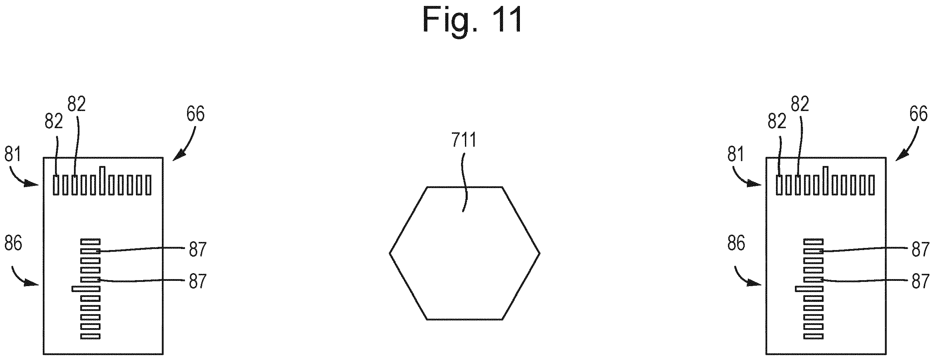

As shown in Figures 7 and 8, in an embodiment one electron-optical element of each pair of electron-optical elements comprises a plurality of alignment fiducials. The other electron-optical element of the pair of electron-optical elements comprises a plurality of monitoring apertures. The monitoring apertures are aligned with respective alignment fiducials in a direction substantially perpendicular to the plane of the electron-optical elements. For example, as shown in Figure 7 and Figure 8, in an embodiment the first electron-optical element 61 comprises two first alignment fiducials 66. The second electron-optical element comprises two first monitoring apertures 71. The first monitoring apertures 71 are aligned with the respective first alignment fiducials 66 in a direction parallel to the beam path, i.e. perpendicular to the plane of the electron-optical elements 61, 62. The two pairs of first monitoring apertures 71 and first alignment fiducials 66 may be on opposite sides of the beam path and/or equidistantly spaced away from each other relative to the midpoint of the respective electron-optical elements 61, 62. Although two pairs of first monitoring apertures 71 and first alignment fiducials 66 are depicted, there may be any number as desired for example three or more. The pairs of first monitoring apertures 71 and first alignment fiducials 66 may be equidistantly spaced around the midpoint of respective electron-optical elements 61, 62 and/or the beam path. Figure 11 schematically depicts two alignment fiducials 66 on opposite sides of the beam paths which pass through the beam area in which the array of apertures 711 are located. The plurality of alignment fiducial-monitoring aperture pairs allows alignment in a rotational direction to be determined (for example around the beam path and/or the orthogonal to the plane of the electron-optical elements 61, 62, which may be referred to as Rz (rotation about the z axis) in addition to alignment within the plane parallel to the electron-optical elements 61, 62, for example in two different directions within the plane, for example x and y axes that may be orthogonal to each other. By providing multiple monitoring apertures distanced from each other, the alignment in Rz is expected to be accurate (e.g. within a range of from about 50µrad to about 500µrad). In an embodiment use of the monitoring apertures and respective fiducials may be used to achieve alignment between the adjoining electron-optical elements in at least three degrees of freedom (for example two different directions in the plane of at least one of the adjoining electron-optical plates and around the beam path). It should be noted that for effective rotational alignment between adjoining electron-optical elements for example around the beam path, at least two pairs of fiducials and monitoring apertures are associated with the adjoining electron-optical elements. For improved alignment, the fiducials are desirably spaced away from the midpoint of the respective electron-optical element.

An embodiment of the invention is expected to enable verification of alignment after each stack assembly step. In an embodiment the illumination light is projected coaxially with the axes extending between the alignment fiducials and their associated monitoring apertures.

In an embodiment, a step of assessing alignment comprises focusing an optical system on an electron-optical element, for example the second electron-optical element 62. This allows marks (e.g. alignment marks or the monitoring aperture) to be determined. Subsequently, the optical system may be focused in a direction parallel to the beam path so as to image the alignment fiducial of the paired electron-optical element for example the first alignment fiducial 66 of the first electron-optical element 61. The first alignment fiducial 66 may be imaged (because it is visible) through the first monitoring aperture 71 of the second electron-optical element 62. One or more errors caused by focusing in the direction parallel to the beam path and/or by tilt of the optical system and/or by lighting effects may be calibrated out by verifying the alignment of the pair of electron-optical elements 61, 62 in two different rotational positions. The two different rotational positions may be offset from each other by 180°. For example, the stack 700 may be rotated between the measurements of the alignment.

In the orientation shown in Figure 7, the direction of electron beams projected toward the sample location is downwards. The sample location is below the stack 700. As shown in Figure 7, in an embodiment the distance between the centre of the beam path and the monitoring apertures increases with increasing distance from the sample location. For example, the first monitoring apertures 71 are further from the central axis of the stack 700 than the second monitoring apertures 72 are distanced from the central axis. Similarly, the second monitoring apertures 72 are further from the centre compared to the third monitoring apertures 73.

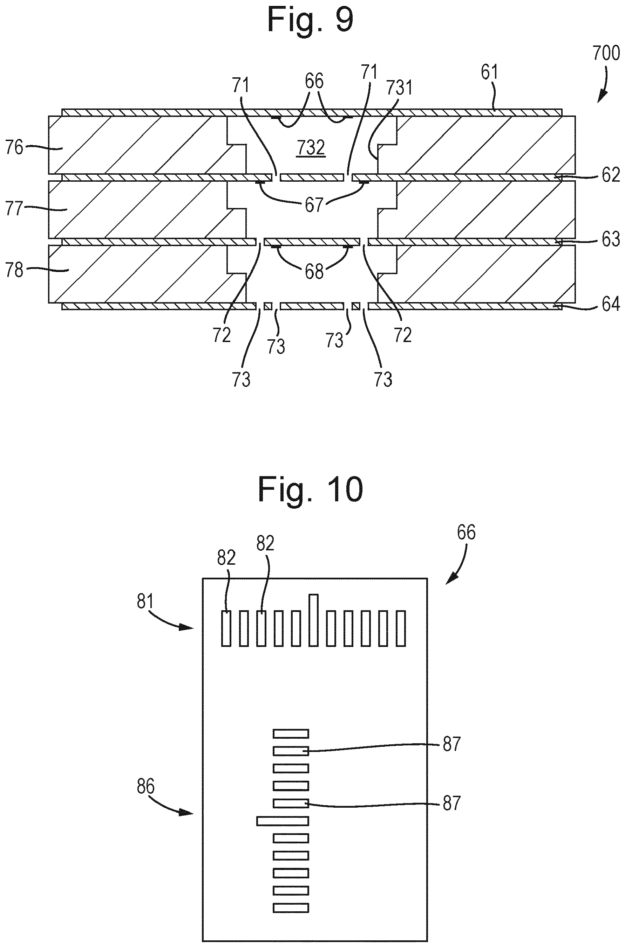

Although the position of the monitoring apertures and fiducials is shown further away from the beam path and/or respective midpoints upbeam in the stack (towards the top of Figure 7) or further from the sample position, the positions may be closer to the beam path further upbeam. It is not essential for the monitoring apertures to be further from the centre as the distance from the sample location increases. In a different embodiment, the position of the monitoring apertures and fiducials may be at different lateral positions for different adjoining pairs of electron-optical elements in the stack. For example, as shown in Figure 9, the first monitoring apertures 71 may be closer to the centre of the beam grid compared to the second monitoring apertures 72. The first monitoring apertures 71 are further from the sample location. In an embodiment the second monitoring apertures 72 are larger than shown in Figure 7 (i.e. larger than the first monitoring apertures). In an embodiment the second monitoring apertures are large enough such that there is a line of sight between the second monitoring apertures 72 and the respective first alignment fiducials 66. This allows the first alignment fiducials 66 to be seen/measured by means of an optical system on the other side of the third electron-optical element 63. Alternatively, as shown in Figure 9 in an embodiment additional monitoring apertures are provide for providing a line of sight through monitoring apertures of an adjoining electron-optical element to the alignment fiducials of the next electron-optical element (i.e. the electron-optical element on the opposite side of the adjoining electron-optical element). For example, as shown in Figure 9 in an embodiment the fourth electron-optical element 64 comprises additional third monitoring apertures aligned with the first monitoring apertures 71, the second monitoring apertures 72 and the first alignment fiducials 66.

As shown in Figures 6-9, in an embodiment the stack 700 comprises a spacer, for example a first spacer 76. The spacer is located between the electron-optical elements of the pair of adjoining electron-optical elements. For example, a first spacer 76 may be located between the first electron-optical element 61 and the second electron-optical element 62. The spacer is configured to physically separate the first electron-optical element 61 from the second electron-optical element 62. In an embodiment the spacer is configured to mechanically support the electron-optical elements. In an embodiment the first spacer 76 is configured to secure the first electron-optical element 61 to the second electron-optical element 62. For example, the first spacer 76 may be fixed to the first electron-optical element 61 and the second electron-optical element 62.

As shown in Figures 7-9, in an embodiment the stack 700 comprises a plurality of spacers. For example, in an embodiment a second spacer 77 is located between the second electron-optical element 62 and the third electron-optical element 63. In an embodiment a third spacer 78 is located between the third electron-optical element 63 and the fourth electron-optical element 64.

As shown in Figure 7, in an embodiment the spacers 76-78 may have inner edges at different distances from the centre of the beam path, i.e. the central axis through the stack 700. For example, Figure 7 shows that the third spacer 78 may have an inner edge that is closer to the centre of the beam path compared to the inner edges of the first spacer 76 and the second spacer 77. Alternatively, as shown in Figure 8 and Figure 9, the inner edges of all of the spacers 76-78 may be similar to each other with respect to the centre of the beam path. The location of the monitoring apertures and fiducials in respective electron-optical elements may be selected so that there is an imaginary straight line between them, so that the imaginary straight line is away from the spacer. That is the imaginary straight line is unoccluded by the spacer intermediate the respective electron-optical elements.

As shown in Figures 7-9, in an embodiment one or more of the spacers 76-78 has an inner edge that is stepped. In an embodiment one or more of the spacers 76-78 gas an inner edge that is a consistent distance from the centre of the beam path.

As shown in Figures 6-9, one or more of the spacers 76-78 comprises a central aperture 732. The central aperture 732 is for passage through the central aperture 732 of electrons along the beam path.

As shown in Figures 7-9 in an embodiment the central aperture 732 has a greater dimension than the monitoring apertures 71 in a direction parallel to the plane of the electron-optical elements 61-64. In an embodiment a plurality of monitoring apertures 71 may fit within the central aperture 732.

In an embodiment, at least one monitoring aperture overlaps the central aperture 732 when viewed in a direction perpendicular to the plane of the electron-optical element 61-64. For example, in Figure 7 it is shown that the first monitoring apertures 71 overlap with the central aperture 732 of the first spacer 76. The first monitoring apertures 71 are within the dimension of the central aperture 732 of the first spacer 76. However, it is not essential for all of the monitoring apertures to overlap with all of the central apertures of the spacers. For example, as shown in Figure 7, the first monitoring apertures 71 and the second monitoring apertures 72 are radially distanced from (e.g. radially outward of) the area defined by the central aperture of the third spacer 78 when viewed in a direction parallel to the beam path. In an embodiment the stack 700 comprises a spacer located between a monitoring aperture and its corresponding fiducial (i.e. the fiducial with which the monitoring aperture is aligned). The spacer may intersect an imaginary straight line between the monitoring aperture and its corresponding fiducial. The spacer may be transparent so as to allow the fiducial to be assessed through the monitoring aperture.

The invention may be embodied as a method for aligning electron-optical elements 61-64. In an embodiment the method comprises forming a stack comprising the first electron-optical element 61 and the second electron-optical element 62. For example, the second electron-optical element 62 may be moved to be located in the stack comprising the first electron-optical element 61. In an embodiment a tool such as a robot arm is used to move the electron-optical elements 61, 64. In an embodiment the first spacer 76 is secured to the first electron-optical element 61. The second electron-optical element 62 is then initially positioned so as to abut the first spacer 76.

In an embodiment the method for aligning electron-optical elements comprises interrogating the first alignment fiducial 66 with interrogation light through the first monitoring aperture 71. In an embodiment a light source for the interrogation light is located such that the first monitoring aperture 71 is located between the light source and the first alignment fiducial 66. The light source is arranged to project interrogation light through the first monitoring aperture 71 towards the first alignment fiducial 66. The interrogation light may be visible light.

In an embodiment the method comprises detecting interrogation light reflected from the first electron-optical element 61. The interrogation light may reflect from a first alignment fiducial 66 and/or from a surface of the first electron-optical element 61 in the vicinity of the first alignment fiducial 66. By detecting the reflected interrogation light, alignment between the first electron-optical element 61 and the second electron-optical element 62 can be assessed, e.g. verified. In an embodiment, assessing alignment between the first electron-optical element 61 and the second electron-optical element 62 comprises assessing the position of the first alignment fiducial 66 with respect to a feature of the second electron-optical element 62. For example, position of the first alignment fiducial 66 with respect to the second alignment fiducial 67 may be measured. In an embodiment the surface of the second electron-optical element facing the first electron-optical element 61 comprises a fiducial for aligning facing sides of the electron-optical elements 61, 62. In an embodiment, when an electron-optical element (e.g. the second electron-optical element 62) is added to the stack 700, the relative position of its monitoring aperture (e.g. the first monitoring aperture 71) and the alignment fiducial (e.g. the first alignment fiducial 66) of the adjoining electron-optical element (e.g. the first electron-optical element 61) is measured with respect to the alignment fiducial (e.g. the second alignment fiducial 67) of the just-placed electron-optical element (e.g. the second electron-optical element 62). This enables the relative position of a further electron-optical element (e.g. the third electron-optical element 63) to be determined relative to the adjoining electron-optical element (e.g. the first electron-optical element 61) when aligning the monitoring aperture (e.g. the second monitoring aperture 72) of the further electron-optical element (e.g. the third electron-optical element 63) with the alignment fiducial (e.g. the second alignment fiducial 67) of the just-placed electron-optical element (e.g. the second electron-optical element 62) (i.e. with reference to and relative to the alignment fiducial of the adjoining electron-optical element enabled by the monitoring aperture of the just-place electron-optical element). In an embodiment the surface of the second electron-optical element facing the first electron-optical element 61 comprises a fiducial for aligning facing sides of the electron-optical elements 61, 62. Additionally or alternatively, position of the first alignment fiducial 66 with respect to the first monitoring aperture 71 may be measured. The first monitoring aperture 71 may be considered to have a dual purpose, namely to enable a view of the first alignment fiducial 66 and also to function as a fiducial (because the first monitoring aperture 71 is used as a reference feature).

As mentioned above, the first alignment fiducial 66 is associated with the first monitoring aperture 71. The first alignment fiducial 66 and the first monitoring aperture 71 may be considered to form an alignment fiducial-monitoring aperture pair. As shown in Figure 7, in an embodiment a plurality of alignment fiducial-monitoring aperture pairs are provided at different locations, i.e. different positions when the stack is viewed in a plan view (in a direction parallel to the electron beam path). Figure 7 shows the first electron-optical element 61 comprising two first alignment fiducials 66. Figure 7 shows the second electron-optical element 62 comprising two first monitoring apertures 71. Figure 7 shows two alignment fiducial-monitoring aperture pairs for aligning the second electron-optical element 62 relative to the first electron-optical element 61. By providing two alignment fiducial-monitoring aperture pairs, two-dimensional alignment in a plane parallel to the electron-optical elements may be assessed, as well as alignment rotationally around an axis parallel to the electron beam path.

It is not essential for two alignment fiducial-monitoring aperture pairs to be provided. In an alternative embodiment, only one alignment fiducial-monitoring aperture pair is provided. In another alternative embodiment, three alignment fiducial-monitoring aperture pairs (or more than three) are provided.

In an embodiment the method comprises aligning the second electron-optical element 62 relative to the first electron-optical element 61 based on the detected interrogation light. For example, if the detected interrogation light indicates that the second electron-optical element is desirably aligned with the first electron-optical element 61, then the second electron-optical element 62 may remain in place. In an embodiment the second electron-optical element 62 is secured relative to the first electron-optical element 61. For example, the second electron-optical element 62 may be fixed relative to the first spacer 76. If the detected interrogation light indicates a misalignment between the first electron-optical element 61 and the second electron-optical element 62, then the method may comprise moving the second electron-optical element 62 so as to be aligned with the first electron-optical element 61. In an embodiment a controller is configured to control movement of the second electron-optical element 62 relative to the first electron-optical element 61 based on the detected interrogation light. For example, the controller may control a tool such as a robot arm to move the second electron-optical element. Alternatively, if the detected interrogation light indicates that the second electron-optical element 62 is misaligned with the first electron-optical element, then the stack may be discarded.

An embodiment of the invention is expected to enable verification of alignment between electron-optical elements within a stack.

As mentioned above and as shown in Figure 7, in an embodiment the stack comprises more than two electron-optical elements. In an embodiment the method for aligning electron-optical elements comprises adding to the stack a third electron-optical element 63. As shown in Figure 7, in an embodiment the third electron-optical element 63 comprises a second monitoring aperture 72.

As shown in Figure 7, in an embodiment the second electron-optical element 62 comprises a second alignment fiducial 67. The second monitoring aperture 72 may be associated with the second alignment fiducial 67. The second alignment fiducial 67 and the second monitoring aperture 72 may form an alignment fiducial-monitoring aperture pair. In an embodiment the second alignment fiducial 67 is visible through the second monitoring aperture 72.

In an embodiment the method comprises interrogating the second alignment fiducial 67 of the second electron-optical element 62 with interrogation light through the second monitoring aperture 72. In the arrangement as shown in Figure 7, the second monitoring aperture 72 is blocked at one side by the third spacer 78. However, during assembly of the stack, the second monitoring aperture 72 is arranged such that interrogation light can pass through the second monitoring aperture 72. The interrogation light may pass through the second monitoring aperture 72 at a time before the third spacer 78 is added to the stack. The third spacer 78 may be added to the stack after alignment of the third electron-optical element 63 relative to the first electron-optical element 61 and/or the second electron-optical element 62 has been verified.

In an embodiment the method comprises detecting interrogation light reflected from the second electron-optical element 62. For example, the interrogation light may be reflected from the second alignment fiducial 67 and/or from part of the second electron-optical element 62 close to the second alignment fiducial 67.

In an embodiment the method comprises aligning the third electron-optical element 63 relative to the second electron-optical element 62 based on the detected interrogation light. For example, the third electron-optical element 63 may be kept in its location if alignment is verified. Alternatively, if alignment is not verified, then the third electron-optical element 63 may be moved or the stack may be discarded.

Figure 8 schematically depicts an alternative arrangement for the stack 700. Features of the stack shown in Figure 8 that are also shown in Figure 7 are not described in detail below so as to avoid redundant description. features of the stack shown in Figure 8 that are different from the stack shown in Figure 7 are described below.

As shown in Figure 8, the second alignment fiducial 67 is not essential. In an embodiment the method comprises interrogating the first alignment fiducial 66 (instead of the second alignment fiducial 67) with interrogation light through the second monitoring aperture 72 in particular, as shown in Figure 8 the first alignment fiducial 66 may be interrogated with interrogation light through both the first monitoring aperture 71 and the second monitoring aperture 72. The light source may be located such that the interrogation light passes through both the second monitoring aperture 72 and the first monitoring aperture 71 so as to reach the first alignment fiducial 66. That is the first monitoring aperture 71 may function as an alignment fiducial with respect to the second monitoring aperture 72. The second monitoring aperture 72 may be considered to have two types of monitoring fiducials: the first monitoring aperture and the first alignment fiducial 66. This may require the first monitoring aperture to be larger than a monitoring aperture that does not serve the function of a fiducial, i.e. that such a monitoring aperture only functions as a monitoring aperture. When using the first monitoring aperture as a fiducial, the fiducial is comprised of the first monitoring aperture because the first fiducial may be too far away in the direction along the beam path (e.g. along the z axis) so that the intensity difference (e.g. contrast) is insufficient.

In an embodiment the method comprises detecting interrogation light reflected from the first electron-optical element 61. For example, the interrogation light may reflect from the first alignment fiducial 66 and/or part of the first electron-optical element 61 near the first alignment fiducial 66.

In an embodiment the method comprises aligning the third electron-optical element 63 relative to the first electron-optical element 61 based on the detected interrogation light. By aligning the third electron-optical element 63 relative to the first electron-optical element 61, the third electron-optical element 63 is also aligned with the second electron-optical element 62. This is because the second electron-optical element 62 has already been aligned with the first electron-optical element. The first monitoring aperture 71 is aligned with the second monitoring aperture 72. An imaginary straight line connecting the first monitoring aperture 71 to the second monitoring aperture 72 is substantially parallel to the electron beam path.

As shown in Figure 7 and in Figure 8, in an embodiment the third electron-optical element 63 comprises a third alignment fiducial 68. In an embodiment the fourth electron-optical element 64 comprises a third monitoring aperture 73. In an embodiment the third alignment fiducial 68 and the third monitoring aperture 73 are associated with each other. The third alignment fiducial 68 is visible through the third monitoring aperture 73. The third alignment fiducial 68 and the third monitoring aperture 73 form an alignment fiducial-monitoring aperture pair.

As shown in Figure 7 and in Figure 8, in an embodiment, a plurality of alignment fiducial-monitoring aperture pairs is provided for each pair of electron-optical elements that are to be aligned relative to each other. In the arrangement shown in Figure 8, when aligning the third electron-optical element 63 relative to the first electron-optical element 61, the first alignment fiducial 66 and the second monitoring aperture 72 form an alignment fiducial-monitoring aperture pair.

Figure 10 schematically shows a type of alignment fiducial according to an embodiment of the invention. The alignment fiducial may be used as a fiducial in an embodiment of the invention, such as any of the embodiments shown in and described with reference to Figures 7 to 9. As shown in Figure 10, in an embodiment the alignment fiducial 66 comprises a plurality of marks 82, 87. The marks 82, 87 may be distanced from each other in a direction parallel to a plane of the electron-optical elements. The view of Figure 10 is of a plane parallel to the plane of the electron-optical elements. As depicted the marks may be a Vernier. A Vernier is a form of two dimensional pattern that may be used as the fiducial according to an embodiment of the invention for example as described in reference to and shown in Figures 7 to 9. In an embodiment, the marks may form any suitable two dimensional pattern such as a grid.

For example, Figure 10 schematically shows an exemplary depiction of the alignment fiducial 66, for example comprising a first plurality 81 of marks 82. The first plurality 81 may be a one dimensional array of the marks 82. The marks may be substantially linear. For example, the marks 82 may be lines. The first plurality 81 of marks 82 may be referred to as a first series of marks (or a sub-pattern). The first plurality 81 of marks 82 may be a Vernier. As a line of marks, the first series of marks may be used for determining the relevant alignment of between adjoining electron-optical elements in the direction of the line of marks for example at the position of the alignment fiducial 66; that is the line of marks may relate to a degree of freedom in the direction of the line of the marks. In an embodiment the first plurality 81 of marks 82 comprises at least three, optionally at least four, optionally at least five, and optionally at least ten marks 82. In an embodiment, the marks 82 are aligned substantially parallel to each other. The marks 82 are visible to the first monitoring aperture 71. When the illumination light is projected onto the first alignment fiducial 66, transitions in intensity of reflected illumination light (or contrast) may be detected. The transitions may correspond to edges of the marks 82. The edges of the marks 82 may be distinct, sharp edges. By detecting the intensity transitions in the image of the first alignment fiducial 66, alignment between the electron-optical elements 61, 62 may be assessed.

By providing a larger number of edge transitions, the accuracy of measuring alignment between the electron-optical elements may be increased. The location fit of the second electron-optical element 62 relative to the first electron-optical element 61 may be averaged over the monitored edge transitions.

In an embodiment, the distance between the marks 82 of the first plurality 81 of marks 82 is known. The marks 82 may be provided at predetermined distances from each other. In an embodiment, a constant pitch is provided between the marks 82. However, it is not essential for the pitch to be constant, particularly provided that the spacing between the marks 82 is known.

As shown in Figure 10, in an embodiment the first alignment fiducial 66 comprises a further plurality of marks, for example the second plurality 86 of marks 87, distanced from each other in a further direction parallel to a plane of the electron-optical elements. The second plurality 86 of marks 87 (or second line of marks) may be a Vernier.

As shown in Figure 10, in an embodiment the first plurality 81 of marks 82 and the second plurality 86 of marks 87 are arranged in different directions, for example perpendicular directions. Otherwise, the second plurality 86 of marks 87 may have substantially the same features as the first plurality 81 of marks 82. By providing two series of marks, desirably orthogonal to each other, the alignment between the electron-optical elements in two dimensions may be assessed with the alignment fiducial 66. For example when used in aligning adjoining electron-optical elements a single alignment fiducial may enable determining relative alignment at the position of the alignment fiducial in two degrees of freedom, for example in the two directions of the first and second lines of marks of the alignment fiducial 66.

However, it is not essential for the first alignment fiducial 66 to comprise an orthogonal series of marks. In an embodiment, the first alignment fiducial 66 comprises one series of marks, for example the first plurality 81 of marks 82. The second plurality 86 of marks 87 may be provided in an further first alignment fiducial 66 at a very different location of the first electron-optical element 61. As shown in Figure 11, in an embodiment alignment fiducials 66 (e.g. as shown in Figure 10) are located on either side of the array of apertures 711. For example, in any embodiment, two first alignment fiducials 66 may be provided on opposite sides of the beam path. This is shown in and described with reference to Figures 7-9, for example. Having two more fiducials spaced away from each other, for example in opposition directions from the array of apertures 711 enables effective rotational alignment, for example between adjoining electron-optical elements. In an embodiment the alignment fiducials on opposites sides of the beam path comprise marks arranged in different directions from each other. Desirably each alignment fiducial comprising at least two lines of marks extending in two different directions angled with respect to each other. In an embodiment each of the two alignment fiducials 66 has a plurality of marks arranged in a line in the direction orthogonal to the direction between the two alignment fiducials 66. In an embodiment one of the two alignment fiducials 66 on opposite sides of the beam area may omit one of the pluralities of marks that extends in the same direction between the two alignment fiducials.

In an embodiment one or more of the planar elements comprises a detector configured to detect signal electrons from the sample location. For example such a detector is as depicted and disclosed with reference to any of the Figures 2 to 5.

In an embodiment the electron-optical module is or comprises an objective lens assembly. The objective lens assembly may comprise an array of objective lenses for focusing electron beams onto a sample location. Such an objection lens assembly is depicted in Figure 3-5 for example. In an embodiment, surfaces of the electron-optical element of at least one pair of electron-optical elements are configured to form the objective lenses 241 when a potential difference is applied between them.

In an embodiment the electron-optical module is or comprises a condenser lens array for deflecting the electrons towards the sample 208. In an embodiment the condenser lens array is for deflecting the electrons towards the sample 208 in one or more electron beams. In an embodiment the condenser lens array is for collimating the electrons towards the sample 208. In an embodiment the electron-optical module is or comprises a macro condenser lens for deflecting the electrons towards the sample 208.

The invention may be embodied as an alignment apparatus comprising the stack 700, and interrogation light source and an alignment detector. The interrogation light source is configured to direct interrogation light through one or more of the monitoring apertures. The alignment detector is configured to detect interrogation light reflected from at least one of the electron-optical elements 61-64. In an embodiment the interrogation light source is located at one side of the stack (in an direction parallel to the beam path). The alignment detector is located at the same side of the stack. The optical system used for assessing the alignment via imaging of the alignment fiducial is reflective. Light reflected from the alignment fiducial or the electron-optical element close to the alignment fiducial is used to assess the alignment. This is different from a transmissive system in which light is transmitted through the stack and detected on the opposite side of the stack.

In an embodiment the stack 700 comprises one or more electron-optical elements which comprise an element which may be referred to as a microelectromechanical component (despite such component may not comprise a moving or moveable feature) or may be made using techniques suited to make microelectromechanical components (for example a 'MEMS technique') some of which are designed to have electron-optical functionality. The stack 700, or at least components of the stack 700, may be manufactured by such techniques. The stack 700 may comprise one or more elements which may be considered MEMS elements. One or more of such elements may be controlled to be set at a high potential difference relative to a reference potential (e.g. ground) during use. Such elements may require accurate positioning (for example alignment) within the stack 700 for example with respect to the path of the beam grid and with respect to other electron-optical elements within the device for example with respect to a source, with respect to a sample and/or the path of the beam grid. An embodiment of the invention is expected to allow for more accurate positioning (for example alignment) of such elements within the stack of such a stack 700 such as during operation for example without distortion of the stack 700 for example by externally applied force or moment. An embodiment of the invention may in addition or alternatively enable more accurate positioning, for example alignment, of such elements with respect to other elements in the device 40 and thus of the stack of the stack 700 comprising such elements within the device 40.

As mentioned above, in an embodiment the stack 700 is an electron-optical lens assembly. The electron-optical lens assembly may comprise an objective lens assembly. The electron-optical lens assembly may be an objective lens assembly. In an alternative embodiment the electron-optical lens assembly is an electron-optical condenser lens assembly.

In an embodiment the stack 700 comprises a collimator. For example, in an embodiment the stack 700 comprises a magnetic collimator in combination with an electro static condenser lens arrays. The stack 700 may comprise a single aperture lens array with one or two macro electrodes, placed away from the virtual source conjugate plane.

In an alternative embodiment, the stack 700 comprises a magnetic macro lens in combination with an electrostatic slit deflector. The magnetic macro lens may be for collimating. As a further alternative, in an embodiment the stack 700 comprises a combined magnetic and electrostatic macro lens and a downbeam slit deflector.

In general, the stack 700 may comprise any plates such as a plate of a detector array, a plate of a lens electrode (into which multiple deflectors may be integrated) multiple deflector arrays, beam aperture arrays (e.g. an upper beam aperture array and/or a final beam limiting array), deflector arrays (e.g. strip deflector arrays) and other types of corrector elements.

The embodiments described within this document have focussed primarily on multi-beam electron-optical devices 40. The invention is equally applicable to single-beam electron-optical devices 40.

While the present invention has been described in connection with various embodiments, other embodiments of the invention will be apparent to those skilled in the art from consideration of the specification and practice of the invention disclosed herein. For example, as described above in an embodiment the stack 700 comprises the monitoring aperture and alignment fiducial. However, a monitoring aperture and alignment fiducial of the invention can be used anywhere in the electron-optical device 40 where a problem of possible misalignment may exist. It is intended that the specification and examples be considered as exemplary only, with a true scope and spirit of the invention being indicated by the following claims and clauses.

The descriptions above are intended to be illustrative, not limiting. Thus, it will be apparent to one skilled in the art that modifications may be made as described without departing from the scope of the claims and clauses set out below.

There is provided the following clauses:
Clause 1. A stack of planar elements for a charged particle-optical module configured to project charged particles along a beam path, the stack comprising: a pair of adjoining planar elements arranged across the beam path, wherein one of the planar elements comprises an alignment fiducial and the other of the planar elements comprises a monitoring aperture; wherein the pair of planar elements are positioned relative to each other such that the alignment fiducial and the monitoring aperture are aligned with each other in a direction substantially perpendicular to a plane of the planar elements.
Clause 2. The stack of clause 1, comprising a further planar element adjoining the planar element that comprises the monitoring aperture, so as to form a further pair of planar elements.
Clause 3. The stack of clause 2, wherein the further planar element comprises a further monitoring aperture.
Clause 4. The stack of clause 3, wherein the monitoring apertures are offset from each other when viewed in a direction perpendicular to the plane of the planar elements.
Clause 5. The stack of clause 3 or 4, wherein the further planar element comprises an additional monitoring aperture, desirably the additional monitoring aperture is aligned with the monitoring aperture of the pair of planar elements.
Clause 6. The stack of any of clauses 3-5, wherein the further pair of planar elements are arranged relative to each other such that the further monitoring aperture of the further planar element and a further alignment fiducial of its paired planar element are aligned with each other in a direction substantially perpendicular to a plane of the planar elements.
Clause 7. The stack of clause 3, wherein the monitoring apertures are aligned with each other in a direction substantially perpendicular to a plane of the planar elements.
Clause 8. The stack of any preceding clause, wherein planar elements respectively comprise one or more openings for charged particles; desirably the one or more openings having a midpoint, desirably on alignment of the alignment fiducial and the monitoring fiducial the midpoints between the respective pair of planar elements is aligned.
Clause 9. The stack of any preceding clause, wherein one planar element of each pair of planar elements comprises a plurality of alignment fiducials and the other planar element of the pair of planar elements comprises a plurality of monitoring apertures aligned with respective alignment fiducials in a direction substantially perpendicular to a plane of the planar elements, desirably the plurality of alignment fiducials is two alignment fiducials, desirably the plurality of monitoring apertures is two, desirably the two alignment fiducials are spaced away from the midpoint in different directions, desirably opposing directions, desirably the alignment fiducials are spaced away from the midpoint by the same distance.
Clause 10. The stack of any preceding clause, comprising a spacer located between the planar elements of at least one pair of planar elements.
Clause 11. The stack of clause 10, wherein the spacer comprises a central aperture for passage therethrough of charged particles along the beam path.
Clause 12. The stack of clause 11, wherein the central aperture has a greater dimension than the each monitoring aperture in a direction parallel to a plane of the planar elements.
Clause 13. The stack of clause 12, wherein at least one monitoring aperture overlaps the central aperture when viewed in a direction perpendicular to a plane of the planar elements.
Clause 14. The stack of any preceding clause, wherein each alignment fiducial comprises a plurality of marks distanced from each other in a plane of the planar elements.
Clause 15. The stack of clause 14, wherein at least some of the plurality of marks are arranged a direction parallel to the plane of the planar elements, desirably the plurality of marks are all arranged in the direction parallel to the plane of the planar elements, desirably the plurality of marks is a vernier.
Clause 16. The stack of clause 14 or 15, wherein at least some of the plurality of marks are arranged in a different direction parallel to the plane of the planar elements.
Clause 17. The stack of any of clauses 14 to 16, wherein the plurality of marks form a pattern such as a grid.
Clause 18. The stack of clause 14 or 15, wherein each alignment fiducial comprises a further plurality of marks distanced from each other in a further direction parallel to a plane of the planar elements such that the pluralities of marks are arranged in perpendicular directions.
Clause 19. The stack of any of clauses 14 to 18, wherein the marks have a periodicity.
Clause 20. The stack of any preceding clause, wherein at least one alignment fiducial comprises a through hole.
Clause 21. The stack of clause 20, wherein each monitoring aperture has a greater dimension than the through hole in a direction parallel to a plane of the planar elements.
Clause 22. The stack of any preceding clause, wherein each of the planar elements comprises or is a plate.
Clause 23. The stack of clause 22, wherein each plate comprises an array of apertures for passage therethrough of respective charged particle beams, desirably along the beam path, desirably during operation the beam path corresponds to the midpoint.
Clause 24. The stack of clause 23, wherein the apertures of the array of apertures have a smaller dimension than the monitoring aperture in a direction parallel to a plane of the planar elements.
Clause 25. The stack of any preceding clause, wherein at least one of the planar elements comprises a microelectromechanical component.
Clause 26. The stack of any preceding clause, wherein at least one of the planar elements is a charged particle-optical element.
Clause 27. The stack of any preceding clause, wherein at least one of the planar elements comprises a detector configured to detect signal charge particles from a sample location.
Clause 28. A charged particle-optical module comprising the stack of any preceding clause.
Clause 29. The charged particle-optical module of clause 28, wherein the charged particle-optical module is or comprises an objective lens assembly comprising an array of objective lenses for focusing charged particle beams onto a sample location or a condenser lens array for deflecting the charged particles towards the sample.
Clause 30. The charged particle-optical module of clause 29, wherein surfaces of the planar elements of at least one pair of planar elements are configured to form the lenses when a potential difference is applied between them.
Clause 31. A charged particle-optical device for directing charged particle beams onto a sample location, the charged particle-optical device comprising the stack of any of clauses 1-27 or the charged particle-optical module of any of clauses 28-30.
Clause 32. A charged particle-optical apparatus comprising the stack of any of clauses 1-27, the charged particle-optical module of any of clauses 28-30 or the charged particle-optical device of clause 31.
Clause 33. The charged particle-optical apparatus of clause 32, further comprising an actuatable stage for supporting a sample at the sample location.
Clause 34. An alignment apparatus comprising: the stack of any of clauses 1-27 or the charged particle-optical module of any of clauses 28-30; an interrogation light source configured to direct interrogation light through at least one monitoring aperture; and an alignment detector configured to detect interrogation light reflected from at least one planar element.
Clause 35. The alignment apparatus of clause 34, wherein the interrogation light source is located at one side of the stack and the alignment detector is located at the same side of the stack.
Clause 36. The alignment apparatus of clause 34 or 35 comprising: a mover configured to align the planar elements relative to each other based on detected interrogation light.
Clause 37. A method for aligning planar elements for a charged particle-optical module configured to project charged particles along a beam path, the method comprising: providing a first planar element comprising a first alignment fiducial; providing a second planar element comprising a first monitoring aperture stacked relative to the first planar element; interrogating the first alignment fiducial with interrogation light through the first monitoring aperture; detecting interrogation light reflected from the first planar element; and aligning the second planar element relative to the first planar element based on the detected interrogation light.
Clause 38. The method of clause 37, comprising: providing a third planar element comprising a second monitoring aperture stacked relative to the second planar element; interrogating the first alignment fiducial or a second alignment fiducial of the second planar element with interrogation light through the second monitoring aperture; detecting interrogation light reflected from the first planar element or the second planar element; and aligning the third planar element relative to the first planar element or the second planar element based on the detected interrogation light.
Clause 39. The method of clause 37 or 38, wherein the aligning step comprises monitoring one or more intensity variations of the reflected interrogation light corresponding to one or more edges of the first alignment fiducial, desirably in two dimensions for example in a plane of the respective planar element.
Clause 40. The method of clause 39, wherein the aligning step comprises monitoring a plurality intensity variations of the reflected interrogation light corresponding to edges of a plurality of marks of the first alignment fiducial, the marks being distanced from each other in a direction parallel to a plane of the first planar element.
Clause 41. The method of any of clauses 37-40, wherein the interrogating step comprises focusing the interrogation light on the first alignment fiducial.
Clause 42. The method of any of clauses 37-41, wherein the interrogation light is directed perpendicular to a plane of the second planar element.
Clause 43. The method of any of clauses 37-42, comprising securing the second planar element relative to the first planar element after the aligning step.
Clause 44. A method of making a charged particle-optical module comprising the method of any of clauses 37-43.

## Claims

1. A stack of planar elements for a charged particle-optical module configured to project charged particles along a beam path, the stack comprising:
a pair of adjoining planar elements arranged across the beam path, wherein one of the planar elements comprises an alignment fiducial and the other of the planar elements comprises a monitoring aperture;
wherein the pair of planar elements are positioned relative to each other such that the alignment fiducial and the monitoring aperture are aligned with each other in a direction substantially perpendicular to a plane of the planar elements.

2. The stack of claim 1, comprising a further planar element adjoining the planar element that comprises the monitoring aperture, so as to form a further pair of planar elements.

3. The stack of claim 2, wherein the further planar element comprises a further monitoring aperture.

4. The stack of claim 3, wherein the monitoring apertures are offset from each other when viewed in a direction perpendicular to the plane of the planar elements.

5. The stack of claim 3 or 4, wherein the further planar element comprises an additional monitoring aperture, desirably the additional monitoring aperture is aligned with the monitoring aperture of the pair of planar elements.

6. The stack of any of claims 3-5, wherein the further pair of planar elements are arranged relative to each other such that the further monitoring aperture of the further planar element and a further alignment fiducial of its paired planar element are aligned with each other in a direction substantially perpendicular to a plane of the planar elements.

7. The stack of claim 3, wherein the monitoring apertures are aligned with each other in a direction substantially perpendicular to a plane of the planar elements.

8. The stack of any preceding claim, wherein planar elements respectively comprise one or more openings for charged particles

9. The stack of any preceding claim, wherein one planar element of each pair of planar elements comprises a plurality of alignment fiducials and the other planar element of the pair of planar elements comprises a plurality of monitoring apertures aligned with respective alignment fiducials in a direction substantially perpendicular to a plane of the planar elements.

10. The stack of any preceding claim, comprising a spacer located between the planar elements of at least one pair of planar elements. wherein the spacer comprises a central aperture for passage therethrough of charged particles along the beam path.

11. The stack of any preceding claim, wherein each alignment fiducial comprises a plurality of marks distanced from each other in a plane of the planar elements.

12. The stack of claim 11, wherein at least some of the plurality of marks are arranged a direction parallel to the plane of the planar elements,

13. The stack of claim 11 or 12 wherein at least some of the plurality of marks are arranged in a different direction parallel to the plane of the planar elements.

14. The stack of claim 11 or 12, wherein each alignment fiducial comprises a further plurality of marks distanced from each other in a further direction parallel to a plane of the planar elements such that the pluralities of marks are arranged in perpendicular directions.

15. A charged particle-optical device for directing charged particle beams onto a sample location, the charged particle-optical device comprising the stack of any of claims 1-14.
